# EUROPEAN PATENT SPECIFICATION

(11) **EP 3 657 253 B1**
(45) Date of publication and mention of the grant of the patent: **30.06.2021**
(21) Application number: 19207599.2
(22) Date of filing: 07.11.2019
(51) Int. Cl.: G03F 7/075, G03F 7/038

(54) **PHOTOSENSITIVE RESIN COMPOSITION, PATTERN FORMING PROCESS, AND ANTIREFLECTION FILM**
LICHTEMPFINDLICHE HARZZUSAMMENSETZUNG, MUSTERERZEUGUNGSVERFAHREN UND ANTIREFLEXIONSFILM
COMPOSITION DE RÉSINE PHOTOSENSIBLE, PROCÉDÉ DE FORMATION DE MOTIFS ET FILM ANTIREFLET

(30) Priority: 19.11.2018 JP 2018216419
(43) Date of publication of application: 27.05.2020
(73) Proprietor: Shin-Etsu Chemical Co., Ltd., Tokyo (JP)
(72) Inventor: MARUYAMA, Hitoshi, Annaka-shi Gunma (JP); OOWADA, Tamotsu, Annaka-shi Gunma (JP)
(74) Representative: Ter Meer Steinmeister & Partner

(56) References cited:
- EP-A1- 2 447 304
- EP-A1- 3 441 818
- WO-A1-2009/017197
- JP-A- 2010 197 559
- US-A1- 2006 188 664

## Description

### TECHNICAL FIELD

This invention relates to a photosensitive resin composition, pattern forming process, and antireflection film.

### BACKGROUND ART

In conjunction with the widespread use of optical devices, it is currently required to impart certain optical properties to transparent materials, typically to impart an antireflection function by forming an antireflection film on the surface thereof. While the antireflection film is generally formed by evaporation or sputtering, there is the increasing demand to form an antireflection film by a wet coating technique which is inexpensive. In the wet coating, organic hard coat agents such as acrylic resins and hard coat agents such as silane compounds are used.

Antireflection films with a low reflectivity are often desired. There is known the technique of forming a transparent film with a low reflectivity by dispersing silica hollow microparticles as a low-reflectivity material in a matrix to formulate a film-forming composition, coating and curing the composition (see Patent Documents 1 and 2). It is also referred to JP-A-2010-197559, which also discloses an antireflective composition for the provision of a low refractive index layer with high hardness, scratch resistance and adhesiveness.

In addition to the low reflectivity, the antireflection films must meet some other requirements. One requirement is a sufficient film strength to improve reliability. The second requirement is the film's microprocessing ability because more optical devices need microfabrication. The third requirement is that the film is resistant to discoloration by light from high-power optical devices.

### Citation List

Patent Document 1: JP-A 2012-137636
Patent Document 2: JP-A 2003-292831
Patent Document 3: JP-A-2010-197559

### DISCLOSURE OF INVENTION

An object of the invention is to provide a photosensitive resin composition which has satisfactory reliability (adhesion and crack resistance), flexibility, lithographic resolution and light resistance while maintaining the function of an antireflection film. Another object is to provide a pattern forming process using the photosensitive resin composition, and a cured film of the photosensitive resin composition having an antireflection function.

The inventors have found that a photosensitive resin composition comprising an acid crosslinkable group-containing silicone resin, a photoacid generator, and hollow silica is easy to form a film, and the resulting film exhibits improved light resistance and improved microprocessing properties such as resolution and thus possesses satisfactory reliability (adhesion and crack resistance) and flexibility while maintaining the function of an antireflection film.

In one aspect, the invention provides a photosensitive resin composition comprising (A) an acid crosslinkable group-containing silicone resin having a weight average molecular weight of 3,000 to 500,000, (B) a photoacid generator, and (C) hollow silica.

Typically, the acid crosslinkable group is an epoxy, oxetane or vinyl ether group.

In a preferred embodiment, component (A) is a silicone resin comprising repeating units having the following formulae (A1) to (A6). 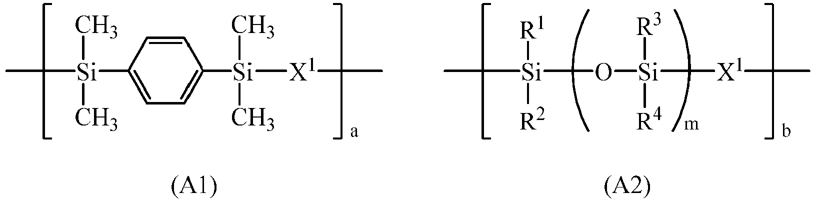 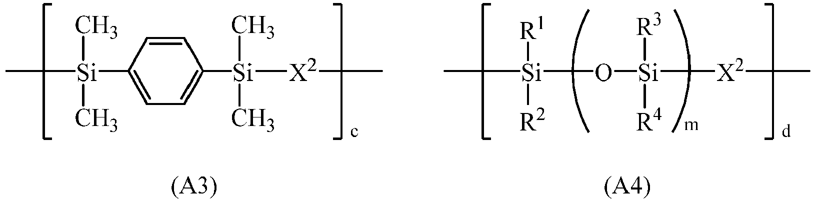 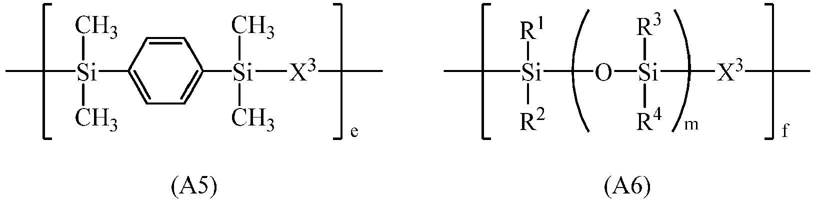 Herein R¹ to R⁴ are each independently a C₁-C₂₀ monovalent hydrocarbon group which may contain a heteroatom, m is each independently an integer of 1 to 600, with the proviso that when m is an integer of at least 2, groups R³ may be identical or different and groups R⁴ may be identical or different, a, b, c, d, e, and f are numbers in the range: 0 ≤ a ≤ 1, 0 ≤ b ≤ 1, 0 ≤ c ≤ 1, 0 ≤ d ≤ 1, 0 ≤ e ≤ 1, 0 ≤ f ≤ 1, 0< c+d+e+f ≤ 1, and a+b+c+d+e+f=1.

X¹ is a divalent group having the formula (X1): 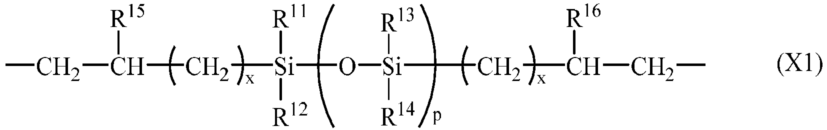 wherein R¹¹ to R¹⁴ are each independently a C₁-C₂₀ monovalent hydrocarbon group which may contain a heteroatom, p is an integer of 1 to 600, with the proviso that when p is an integer of at least 2, groups R¹³ may be identical or different and groups R¹⁴ may be the same or different, R¹⁵ and R¹⁶ are each independently hydrogen or methyl, x is each independently an integer of 0 to 7.

X² is a divalent group having the formula (X2): 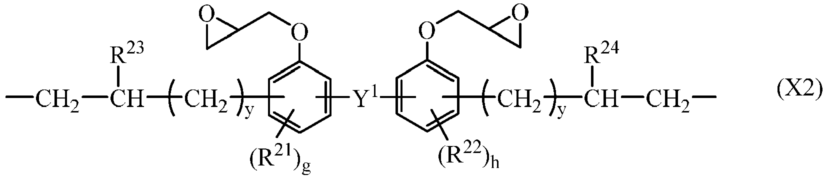 wherein Y¹ is a single bond, methylene, propane-2,2-diyl,
1,1,1,3,3,3-hexafluoropropane-2,2-diyl, or fluorene-9,9-diyl, R²¹ and R²² are each independently a C₁-C₄ alkyl or alkoxy group, with the proviso that when g is 2, groups R²¹ may be identical or different, when h is 2, groups R²² may be identical or different, R²³ and R²⁴ are each independently hydrogen or methyl, y is each independently an integer of 0 to 7, g and h are each independently 0, 1 or 2.

X³ is a divalent group having the formula (X3): 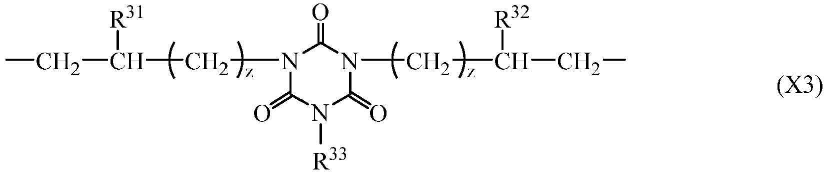 wherein R³¹ and R³² are each independently hydrogen or methyl, z is each independently an integer of 0 to 7, R³³ is a C₁-C₈ monovalent hydrocarbon group which may contain an ester bond or ether bond, or a monovalent group having the formula (X3-1): 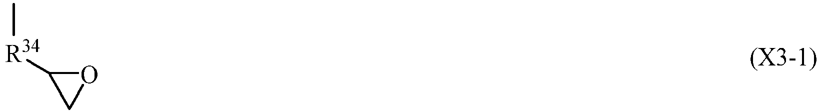 wherein R³⁴ is a C₁-C₈ divalent hydrocarbon group which may contain an ester bond or ether bond.

In a preferred embodiment, the hollow silica (C) has an average particle size of up to 1 µm. Also preferably, the hollow silica (C) is present in an amount of 20 to 90% by weight of the composition.

The photosensitive resin composition may further comprise (D) a crosslinker, (E) an antioxidant, and/or (F) a solvent.

In another aspect, the invention provides a pattern forming process comprising the steps of:
(i) coating the photosensitive resin composition defined above onto a substrate to form a photosensitive resin film thereon,
(ii) exposing the photosensitive resin film to radiation, and
(iii) developing the exposed resin film in a developer.

In a further aspect, the invention provides a method for preparing an antireflection film, involving the pattern forming process defined above, the antireflection film comprising the patterned photosensitive resin film.

In a further aspect, the invention provides an antireflection film comprising the photosensitive resin composition defined above.

Also contemplated herein is an article comprising the antireflection film defined above.

### ADVANTAGEOUS EFFECTS OF INVENTION

The photosensitive resin composition comprising a specific acid crosslinkable group-containing silicone resin, a photoacid generator, and hollow silica may be effectively coated to form a film. The film functions as an antireflection film, exhibits light resistance and improved microprocessing properties such as resolution, and thus possesses satisfactory reliability (adhesion and crack resistance) and flexibility.

### DESCRIPTION OF PREFERRED EMBODIMENTS

The notation (Cn-Cm) means a group containing from n to m carbon atoms per group. "Optional" or "optionally" means that the subsequently described event or circumstances may or may not occur, and that description includes instances where the event or circumstance occurs and instances where it does not. PAG stands for photoacid generator.

### Photosensitive resin composition

One embodiment of the invention is a photosensitive resin composition comprising (A) an acid crosslinkable group-containing silicone resin having a weight average molecular weight of 3,000 to 500,000, (B) a photoacid generator, and (C) hollow silica according to claim 1.

### (A) Acid crosslinkable group-containing silicone resin

The acid crosslinkable group-containing silicone resin as component (A) is a resin of siloxane structure having an acid crosslinkable group. As used herein, the acid crosslinkable group refers to a group capable of forming a chemical bond under the action of an acid. Preferred examples of the acid crosslinkable group include epoxy, oxetane and vinyl ether groups, with the epoxy groups being most preferred.

The preferred silicone resin as component (A) is an epoxy-containing silicone resin comprising repeating units having the following formulae (A1) to (A6), which are simply referred to as repeating units (A1) to (A6).

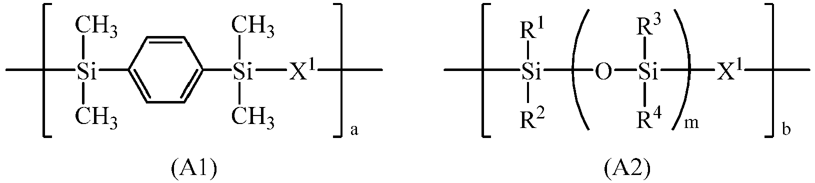

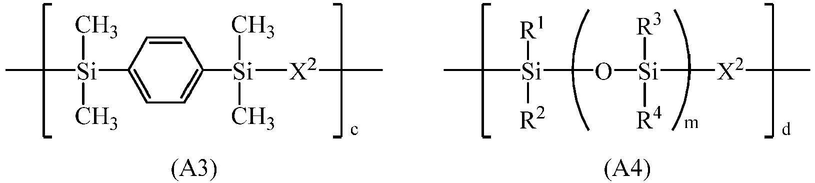

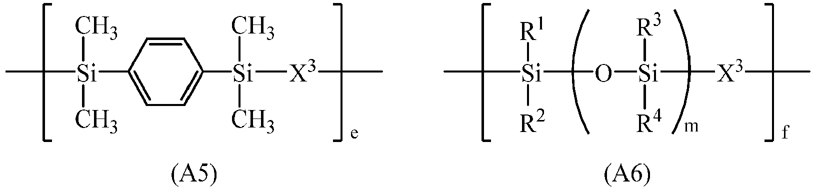

In formulae (A2), (A4) and (A6), R¹ to R⁴ are each independently a C₁-C₂₀ monovalent hydrocarbon group which may contain a heteroatom, and m is each independently an integer of 1 to 600. When m is an integer of at least 2, groups R³ may be identical or different and groups R⁴ may be identical or different. In the repeating units (A2), (A4) and (A6), where at least two siloxane units are included, the siloxane units may be all identical, or at least two different siloxane units may be included. Where at least two different siloxane units are included (i.e., m is an integer of at least 2), the siloxane units may be bonded randomly or alternately, or a plurality of blocks each consisting of identical siloxane units may be included.

The monovalent hydrocarbon groups may be straight, branched or cyclic and include monovalent aliphatic hydrocarbon groups such as C₁-C₂₀ alkyl groups and C₂-C₂₀ alkenyl groups, and monovalent aromatic hydrocarbon groups such as C₆-C₂₀ aryl groups and C₇-C₂₀ aralkyl groups.

Suitable alkyl groups include methyl, ethyl, n-propyl, isopropyl, cyclopropyl, n-butyl, isobutyl, sec-butyl, tert-butyl, cyclobutyl, n-pentyl, cyclopentyl, n-hexyl, cyclohexyl, n-heptyl, n-octyl, n-nonyl, n-decyl, norbornyl and adamantyl. Suitable alkenyl groups include vinyl, propenyl, butenyl and pentenyl.

The monovalent aliphatic hydrocarbon group may contain a heteroatom. Specifically, in the monovalent aliphatic hydrocarbon group, some or all of the hydrogen atoms may be substituted by halogen atoms such as fluorine, chlorine, bromine and iodine, or a carbonyl moiety, ether bond or thioether bond may intervene between carbon atoms. Typical of the heteroatom-containing aliphatic hydrocarbon group is 2-oxocyclohexyl.

Suitable aryl groups include phenyl, 2-methylphenyl, 3-methylphenyl, 4-methylphenyl, 2-ethylphenyl, 3-ethylphenyl, 4-ethylphenyl, 4-tert-butylphenyl, 4-butylphenyl, dimethylphenyl, naphthyl, biphenylyl, and terphenylyl. Suitable aralkyl groups include benzyl and phenethyl.

The monovalent aromatic hydrocarbon group may contain a heteroatom. Specifically, some or all hydrogen atoms may be substituted by C₁-C₁₀ alkoxy, C₁-C₁₀ alkylthio, C₆-C₂₀ aryloxy or C₆-C₂₀ arylthio groups.

Suitable C₁-C₁₀ alkoxy groups include methoxy, ethoxy, n-propyloxy, isopropyloxy, cyclopropyloxy, n-butyloxy, isobutyloxy, sec-butyloxy, tert-butyloxy, cyclobutyloxy, n-pentyloxy, cyclopentyloxy, n-hexyloxy, cyclohexyloxy, n-heptyloxy, n-octyloxy, n-nonyloxy, n-decyloxy, norbornyloxy, and adamantyloxy.

Suitable C₁-C₁₀ alkylthio groups include methylthio, ethylthio, n-propylthio, isopropylthio, cyclopropylthio, n-butylthio, isobutylthio, sec-butylthio, tert-butylthio, cyclobutylthio, n-pentylthio, cyclopentylthio, n-hexylthio, cyclohexylthio, n-heptylthio, n-octylthio, n-nonylthio, n-decylthio, norbornylthio, and adamantylthio.

Suitable C₆-C₂₀ aryloxy groups include phenyloxy, 2-methylphenyloxy, 3-methylphenyloxy, 4-methylphenyloxy, 2-ethylphenyloxy, 3-ethylphenyloxy, 4-ethylphenyloxy, 4-tert-butylphenyloxy, 4-butylphenyloxy, dimethylphenyloxy, naphthyloxy, biphenylyloxy, and terphenylyloxy.

Suitable C₆-C₂₀ arylthio groups include phenylthio, 2-methylphenylthio, 3-methylphenylthio, 4-methylphenylthio, 2-ethylphenylthio, 3-ethylphenylthio, 4-ethylphenylthio, 4-tert-butylphenylthio, 4-butylphenylthio, dimethylphenylthio, naphthylthio, biphenylylthio, and terphenylylthio.

Suitable substituted aryl groups include 2-methoxyphenyl, 3-methoxyphenyl, 4-methoxyphenyl, 2-ethoxyphenyl, 3-ethoxyphenyl, 4-ethoxyphenyl, 3-tert-butoxyphenyl, 4-tert-butoxyphenyl, biphenylyloxyphenyl, and biphenylylthiophenyl.

The monovalent aliphatic hydrocarbon groups preferably have 1 to 10 carbon atoms, more preferably 1 to 8 carbon atoms. The monovalent aromatic hydrocarbon groups preferably have 6 to 14 carbon atoms, more preferably 6 to 10 carbon atoms.

Of the foregoing groups, R¹ to R⁴ are preferably selected from methyl, ethyl, n-propyl and phenyl, more preferably methyl and phenyl.

In formulae (A2), (A4) and (A6), m is each independently an integer of 1 to 600, preferably 1 to 300, and more preferably 1 to 100.

In formulae (A1) to (A6), a, b, c, d, e, and f are numbers in the range: 0 ≤ a ≤ 1, 0 ≤ b ≤ 1, 0 ≤ c ≤ 1, 0 ≤ d ≤ 1, 0 ≤ e ≤ 1, 0 ≤ f ≤ 1, 0 < c+d+e+f ≤ 1, and a+b+c+d+e+f=1; preferably 0.2 ≤ a+c+e ≤ 0.95, 0.05 ≤ b+d+f ≤ 0.8, 0 ≤ a+b ≤ 0.9, 0 ≤ c+d ≤ 0.7, 0 < e+f ≤ 1, and a+b+c+d+e+f=1;
more preferably 0.3 ≤ a+c+e ≤ 0.9, 0.1 ≤ b+d+f ≤ 0.7, 0 ≤ a+b ≤ 0.6, 0 ≤ c+d ≤ 0.4, 0.4 ≤ e+f ≤ 1, and a+b+c+d+e+f=1.

In formulae (A1) and (A2), X¹ is a divalent group having the formula (X1).

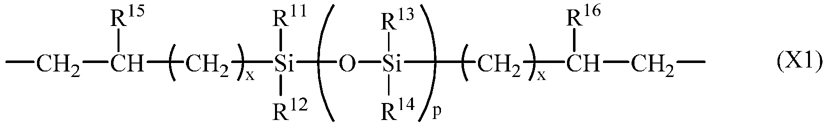

In formula (X1), R¹¹ to R¹⁴ are each independently a C₁-C₂₀ monovalent hydrocarbon group which may contain a heteroatom, and p is an integer of 1 to 600. When p is an integer of at least 2, groups R¹³ may be identical or different and groups R¹⁴ may be identical or different. R¹⁵ and R¹⁶ are each independently hydrogen or methyl, and x is each independently an integer of 0 to 7. In the group of formula (X1), where at least two siloxane units are included, the siloxane units may be all identical, or at least two different siloxane units may be included. Where at least two different siloxane units are included (i.e., p is an integer of at least 2), the siloxane units may be bonded randomly or alternately, or a plurality of blocks each consisting of identical siloxane units may be included.

The monovalent hydrocarbon group which may contain a heteroatom may be straight, branched or cyclic and examples thereof are as exemplified above for R¹ to R⁴. Among others, R¹¹ to R¹⁴ are preferably selected from methyl, ethyl, n-propyl, and phenyl, more preferably methyl and phenyl.

In formulae (A3) and (A4), X² is a divalent group having the formula (X2).

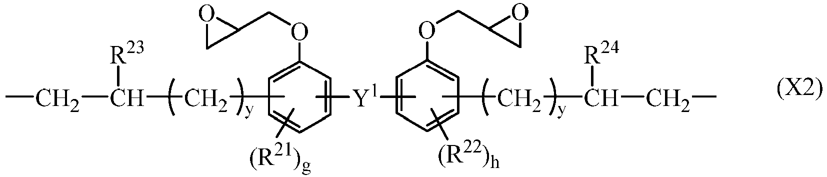

In formula (X2), Y¹ is a single bond, methylene, propane-2,2-diyl, 1,1,1,3,3,3-hexafluoropropane-2,2-diyl, or fluorene-9,9-diyl. R²¹ and R²² are each independently a C₁-C₄ alkyl or alkoxy group, g and h are each independently 0, 1 or 2. When g is 2, groups R²¹ may be identical or different. When h is 2, groups R²² may be identical or different. R²³ and R²⁴ are each independently hydrogen or methyl, y is each independently an integer of 0 to 7.

In formulae (A5) and (A6), X³ is a divalent group having the formula (X3).

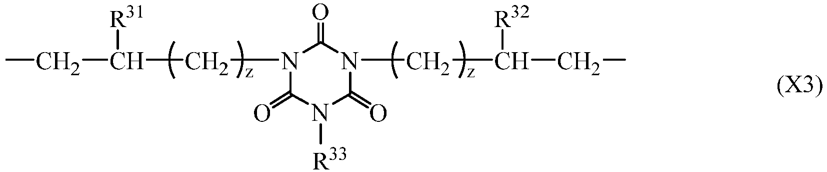

In formula (X3), R³¹ and R³² are each independently hydrogen or methyl, and z is each independently an integer of 0 to 7.

In formula (X3), R³³ is a C₁-C₈ monovalent hydrocarbon group which may contain an ester bond or ether bond, or a monovalent group having the formula (X3-1).

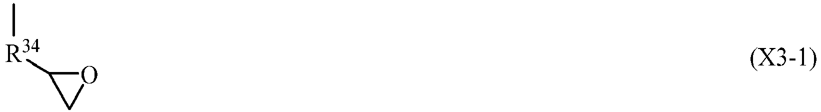

The monovalent hydrocarbon group may be straight, branched or cyclic and examples thereof include alkyl groups such as methyl, ethyl and n-propyl, and aryl groups such as phenyl. Inter alia, methyl and phenyl are preferred, with methyl being most preferred. In the monovalent hydrocarbon group, an ester bond or ether bond may intervene between carbon atoms.

In formula (X3-1), R³⁴ is a C₁-C₈ divalent hydrocarbon group which may contain an ester bond or ether bond. The divalent hydrocarbon group may be straight, branched or cyclic and examples thereof include alkanediyl groups such as methylene, ethylene, propane-1,2-diyl, propane-1,3-diyl, butane-1,2-diyl, butane-1,3-diyl, and butane-1,4-diyl. Among others, methylene and ethylene are preferred, with methylene being more preferred. In the divalent hydrocarbon group, an ester bond or ether bond may intervene between carbon atoms.

R³³ is preferably methyl, phenyl or glycidyl, more preferably methyl or glycidyl.

The repeating units (A1) to (A6) may be bonded randomly or blockwise. The acid crosslinkable group-containing silicone resin preferably has a silicone (siloxane unit) content of 30 to 80% by weight.

The acid crosslinkable group-containing silicone resin has a weight average molecular weight (Mw) of 3,000 to 500,000, preferably 5,000 to 200,000. Throughout the disclosure, Mw is measured versus polystyrene standards by gel permeation chromatography (GPC) using tetrahydrofuran (THF) as eluent.

The silicone resin (A) may be prepared, for example, by mixing necessary amounts of a vinyl-containing compound and a hydrosilyl-containing organosilicon compound (corresponding to the relevant portions in the silicone resin) and conducting hydrosilylation reaction in a standard way.

The acid crosslinkable group-containing silicone resin may be used alone or in admixture of two or more. (B) Photoacid generator

The photoacid generator as component (B) is not particularly limited as long as it is decomposed to generate an acid upon light exposure, preferably it is decomposed to generate an acid upon exposure to light of wavelength 190 to 500 nm. The PAG (B) serves as a curing catalyst. Suitable PAGs include onium salts, diazomethane derivatives, glyoxime derivatives, β-ketosulfone derivatives, disulfone derivatives, nitrobenzyl sulfonate derivatives, sulfonic acid ester derivatives, imidoyl sulfonate derivatives, oxime sulfonate derivatives, iminosulfonate derivatives, and triazine derivatives.

Exemplary onium salts include sulfonium salts having the formula (B1) and iodonium salts having the formula (B2).

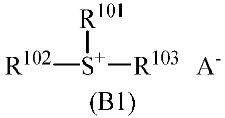

R¹⁰⁴-I⁺-R¹⁰⁵ A⁻ (B2)

In formulae (B1) and (B2), R¹⁰¹ to R¹⁰⁵ are each independently an optionally substituted C₁-C₁₂ alkyl group, an optionally substituted C₆-C₁₂ aryl group, or an optionally substituted C₇-C₁₂ aralkyl group. A⁻ is a non-nucleophilic counter ion.

The alkyl groups may be straight, branched or cyclic and include, for example, methyl, ethyl, n-propyl, isopropyl, cyclopropyl, n-butyl, isobutyl, sec-butyl, tert-butyl, cyclobutyl, n-pentyl, cyclopentyl, cyclohexyl, norbornyl and adamantyl. The aryl groups include phenyl, naphthyl and biphenylyl. The aralkyl groups include benzyl and phenethyl. Suitable substituents on these groups include oxo, straight, branched or cyclic C₁-C₁₂ alkoxy, straight, branched or cyclic C₁-C₁₂ alkyl, C₆-C₂₄ aryl, C₇-C₂₅ aralkyl, C₆-C₂₄ aryloxy, and C₆-C₂₄ arylthio groups.

Preferred examples of R¹⁰¹ to R¹⁰⁵ include optionally substituted alkyl groups such as methyl, ethyl, propyl, butyl, cyclohexyl, norbornyl, adamantyl and 2-oxocyclohexyl; optionally substituted aryl groups such as phenyl, naphthyl, biphenylyl, o-, m- or p-methoxyphenyl, ethoxyphenyl, m- or p-tert-butoxyphenyl, 2-, 3- or 4-methylphenyl, ethylphenyl, 4-tert-butylphenyl, 4-butylphenyl, dimethylphenyl, terphenylyl, biphenylyl, oxyphenyl, and biphenylylthiophenyl; and optionally substituted aralkyl groups such as benzyl and phenethyl. Of these, optionally substituted aryl groups and optionally substituted aralkyl groups are more preferred.

Examples of the non-nucleophilic counter ion include halide ions such as chloride and bromide; fluoroalkkanesulfonate ions such as triflate, 1,1,1-trifluoroethanesulfonate, and nonafluorobutanesulfonate; arylsulfonate ions such as tosylate, benzenesulfonate, 4-fluorobenzenesulfonate, and 1,2,3,4,5-pentafluorobenzenesulfonate; alkanesulfonate ions such as mesylate and butanesulfonate; fluoroalkanesulfonimide ions such as trifluoromethanesulfonimide; fluoroalkanesulfonylmethide ions such as tris(trifluoromethanesulfonyl)methide; and borate ions such as tetrakisphenylborate and tetrakis(pentafluorophenyl) borate.

Exemplary diazomethane derivatives include compounds having the formula (B3).

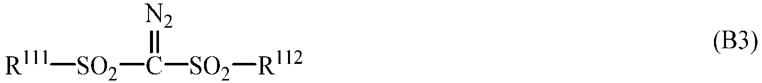

In formula (B3), R¹¹¹ and R¹¹² are each independently a C₁-C₁₂ alkyl or haloalkyl group, an optionally substituted C₆-C₁₂ aryl group, or a C₇-C₁₂ aralkyl group.

The alkyl group may be straight, branched or cyclic and examples thereof are as exemplified above for R¹⁰¹ to R¹⁰⁵. Examples of the haloalkyl group include trifluoromethyl, 1,1,1-trifluoroethyl, 1,1,1-trichloroethyl, and nonafluorobutyl.

Examples of the optionally substituted aryl group include phenyl; alkoxyphenyl groups such as 2-, 3- or 4-methoxyphenyl, 2-, 3- or 4-ethoxyphenyl, 3- or 4-tert-butoxyphenyl; alkylphenyl groups such as 2-, 3- or 4-methylphenyl, ethylphenyl, 4-tert-butylphenyl, 4-butylphenyl, and dimethylphenyl; and haloaryl groups such as fluorophenyl, chlorophenyl, and 1,2,3,4,5-pentafluorophenyl. Examples of the aralkyl group include benzyl and phenethyl.

Exemplary glyoxime derivatives include compounds having the formula (B4).

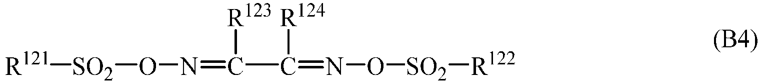

In formula (B4), R¹²¹ to R¹²⁴ are each independently a C₁-C₁₂ alkyl or haloalkyl group, an optionally substituted C₆-C₁₂ aryl group, or a C₇-C₁₂ aralkyl group. R¹²³ and R¹²⁴ may bond together to form a ring with the carbon atoms to which they are attached. In the case of ring formation, R¹²³ bonds with R¹²⁴ to form a C₁-C₁₂ straight or branched alkylene group.

Examples of the alkyl, haloalkyl, optionally substituted aryl and aralkyl groups are as exemplified above for R¹¹¹ and R¹¹². Examples of the straight or branched alkylene group include methylene, ethylene, propylene, butylene, and hexylene.

Examples of the onium salts include
diphenyliodonium trifluoromethanesulfonate, (p-tert-butoxyphenyl)phenyliodonium trifluoromethanesulfonate, diphenyliodonium p-toluenesulfonate, (p-tert-butoxyphenyl)phenyliodonium p-toluenesulfonate,
triphenylsulfonium trifluoromethanesulfonate, (p-tert-butoxyphenyl)diphenylsulfonium trifluoromethanesulfonate, bis(p-tert-butoxyphenyl)phenylsulfonium trifluoromethanesulfonate, tris(p-tert-butoxyphenyl)sulfonium trifluoromethanesulfonate, triphenylsulfonium p-toluenesulfonate, (p-tert-butoxyphenyl)diphenylsulfonium p-toluenesulfonate, bis(p-tert-butoxyphenyl)phenylsulfonium p-toluenesulfonate, tris(p-tert-butoxyphenyl)sulfonium p-toluenesulfonate,
triphenylsulfonium nonafluorobutanesulfonate, triphenylsulfonium butanesulfonate, trimethylsulfonium trifluoromethanesulfonate, trimethylsulfonium p-toluenesulfonate, cyclohexylmethyl(2-oxocyclohexyl)sulfonium trifluoromethanesulfonate, cyclohexylmethyl(2-oxocyclohexyl)sulfonium p-toluenesulfonate,
dimethylphenylsulfonium trifluoromethanesulfonate,
dimethylphenylsulfonium p-toluenesulfonate,
dicyclohexylphenylsulfonium trifluoromethanesulfonate,
dicyclohexylphenylsulfonium p-toluenesulfonate, bis(4-tert-butylphenyl)iodonium hexafluorophosphate, diphenyl(4-thiophenoxyphenyl)sulfonium hexafluoroantimonate, [4-(4-biphenylylthio)phenyl]-4-biphenylylphenylsulfonium tris(trifluoromethanesulfonyl)-methide,
triphenylsulfonium tetrakis(fluorophenyl)borate, tris[4-(4-acetylphenyl)thiophenyl]sulfonium tetrakis(fluorophenyl)borate, triphenylsulfonium tetrakis(pentafluorophenyl)borate, and tris[4-(4-acetylphenyl)thiophenyl]sulfonium tetrakis(pentafluorophenyl)borate.

Examples of the diazomethane derivatives include bis(benzenesulfonyl)diazomethane, bis(p-toluenesulfonyl)diazomethane, bis(xylenesulfonyl)diazomethane, bis(cyclohexylsulfonyl)diazomethane, bis(cyclopentylsulfonyl)diazomethane, bis(n-butylsulfonyl)diazomethane, bis(isobutylsulfonyl)diazomethane, bis(sec-butylsulfonyl)diazomethane, bis(n-propylsulfonyl)diazomethane, bis(isopropylsulfonyl)diazomethane, bis(tert-butylsulfonyl)diazomethane, bis(n-pentylsulfonyl)diazomethane, bis(isopentylsulfonyl)diazomethane, bis(sec-pentylsulfonyl)diazomethane, bis(tert-pentylsulfonyl)diazomethane, 1-cyclohexylsulfonyl-1-(tert-butylsulfonyl)diazomethane, 1-cyclohexylsulfonyl-1-(tert-pentylsulfonyl)diazomethane, and 1-tert-pentylsulfonyl-1-(tert-butylsulfonyl)diazomethane.

Examples of the glyoxime derivatives include bis-O-(p-toluenesulfonyl)-α-dimethylglyoxime, bis-O-(p-toluenesulfonyl)-α-diphenylglyoxime, bis-O-(p-toluenesulfonyl)-α-dicyclohexylglyoxime, bis-O-(p-toluenesulfonyl)-2,3-pentanedioneglyoxime, bis-O-(p-toluenesulfonyl)-2-methyl-3,4-pentanedioneglyoxime, bis-O-(n-butanesulfonyl)-α-dimethylglyoxime, bis-O-(n-butanesulfonyl)-α-diphenylglyoxime, bis-O-(n-butanesulfonyl)-α-dicyclohexylglyoxime, bis-O-(n-butanesulfonyl)-2,3-pentanedioneglyoxime, bis-O-(n-butanesulfonyl)-2-methyl-3,4-pentanedioneglyoxime, bis-O-(methanesulfonyl)-α-dimethylglyoxime, bis-O-(trifluoromethanesulfonyl)-α-dimethylglyoxime, bis-O-(1,1,1-trifluoroethanesulfonyl)-α-dimethylglyoxime, bis-O-(tert-butanesulfonyl)-α-dimethylglyoxime, bis-O-(perfluorooctanesulfonyl)-α-dimethylglyoxime, bis-O-(cyclohexanesulfonyl)-α-dimethylglyoxime, bis-O-(benzenesulfonyl)-α-dimethylglyoxime, bis-O-(p-fluorobenzenesulfonyl)-α-dimethylglyoxime, bis-O-(p-tert-butylbenzenesulfonyl)-α-dimethylglyoxime, bis-O-(xylenesulfonyl)-α-dimethylglyoxime, and bis-O-(camphorsulfonyl)-α-dimethylglyoxime.

Examples of the β-ketosulfone derivatives include 2-cyclohexylcarbonyl-2-(p-toluenesulfonyl)propane and 2-isopropylcarbonyl-2-(p-toluenesulfonyl)propane.

Examples of the disulfone derivatives include diphenyl disulfone and dicyclohexyl disulfone.

Examples of the nitrobenzyl sulfonate derivatives include 2,6-dinitrobenzyl p-toluenesulfonate and 2,4-dinitrobenzyl p-toluenesulfonate.

Examples of the sulfonic acid ester derivatives include 1,2,3-tris(methanesulfonyloxy)benzene, 1,2,3-tris(trifluoromethanesulfonyloxy)benzene, and 1,2,3-tris(p-toluenesulfonyloxy)benzene.

Examples of the imido-yl sulfonate derivatives include phthalimidoyl triflate, phthalimidoyl tosylate, 5-norbornene-2,3-dicarboxyimidoyl triflate, 5-norbornene-2,3-dicarboxyimidoyl tosylate, 5-norbornene-2,3-dicarboxyimidoyl n-butylsulfonate, and n-trifluoromethylsulfonyloxynaphthylimide.

Typical of the oxime sulfonate derivative is α-(benzenesulfoniumoxyimino)-4-methylphenylacetonitrile.

Examples of the iminosulfonate derivatives include (5-(4-methylphenyl)sulfonyloxyimino-5H-thiophen-2-ylidene)-(2-methylphenyl)acetonitrile and (5-(4-(4-methylphenylsulfonyloxy)phenylsulfonyloxyimino)-5H-thiophen-2-ylidene)-(2-methylphenyl)acetonitrile, as well as 2-methyl-2-[(4-methylphenyl)sulfonyl]-1-[(4-methylthio)phenyl]-1-propane.

As the PAG, the onium salts are preferred, with the sulfonium salts being more preferred.

Preferably the PAG (B) is used in an amount of 0.05 to 20 parts by weight, more preferably 0.2 to 5 parts by weight per 100 parts by weight of component (A). An amount of PAG in the range ensures sufficient photo-curability. To acquire transparency and light resistance characteristic of the invention, the amount of photo-absorptive PAG (B) is as small as possible within the range that insures photo-curability. The PAG may be used alone or in admixture.

### (C) Hollow silica

Component (C) is hollow silica in the form of particles of silica derived from a silicon compound or organosilicon compound, that is, silica particles having a space or pore in the surface and/or the interior thereof. The hollow silica acts as a low refractive index agent for imparting an antireflection effect to a cured film.

The hollow or balloon silica may take a sphere, chain, needle, plate, flake, rod, fiber or irregular shape, with the sphere or needle shape being preferred. The hollow silica of spherical shape should preferably have an average particle size of 1 to 1,000 nm, more preferably 5 to 500 nm, even more preferably 10 to 100 nm. When the average particle size is in the range, spherical nanoparticles are effective for imparting transparency to a cured film. As used herein, the average particle size may be determined by a particle size distribution measuring system based on the laser light diffraction method as a weight average value D₅₀ (particle diameter corresponding to a cumulative weight of 50%, or median diameter). The hollow silica may be in crystalline, sol or gel form.

If necessary, the hollow silica may be surface treated with a silane coupling agent prior to use. The surface treatment is preferred because the surface treated hollow silica is more compatible with the silicone resin (A). Then a cured film which is unsusceptible to whitening and more transparent is obtainable.

The hollow silica is commercially available, for example, silica organosol under the tradename of Thrulya® series from JGC C&C, meso-porous silica under the tradename of TMPS® series from Taiyo Kagaku Co., Ltd., and hollow silica under the tradename of SiliNax® series from Nittetsu Mining Co., Ltd.

An appropriate amount of component (C) is 20 to 90% by weight, more preferably 30 to 70% by weight based on the total weight of components (A) to (C). When the amount of component (C) is at least 20 wt%, a film having an antireflection function despite a low refractive index is obtainable. When the amount of component (C) is up to 90 wt%, there is no risk that the composition loses fluidity and becomes inconvenient to mold, leaving unfilled cavities or voids. The hollow silica as component (C) may be used alone or in admixture.

### (D) Crosslinker

The photosensitive resin composition may further comprise (D) a crosslinker. The crosslinker reacts with epoxy groups on component (A) to facilitate pattern formation and serves to increase the strength of a resin film as photo-cured.

The crosslinker is preferably selected from compounds having on the average at least two epoxy groups, alicyclic epoxy groups, or oxetane groups per molecule. Preferred such compounds are low or high molecular weight compounds having a Mw of 100 to 20,000, more preferably 200 to 10,000. A compound having a Mw of at least 100 provides sufficient photo-cure whereas a compound having a Mw of up to 20,000 does not exacerbate the heat resistance of a composition as photo-cured.

An amount of component (D) is 0 to 100 parts by weight per 100 parts by weight of component (A), and when used, preferably 0.5 to 100 parts, more preferably 1 to 50 parts by weight. When the amount of component (D) is at least 0.5 part, sufficient cure upon light exposure is obtainable. When the amount of component (D) is up to 100 parts, the proportion of component (A) in the composition is not so reduced, allowing a cured composition to exert the desired effect. Component (D) may be used alone or in admixture.

### (E) Antioxidant

The photosensitive resin composition may further contain (E) an antioxidant as an additive which is effective for improving heat resistance. The antioxidant is preferably selected from hindered phenol compounds and hindered amine compounds.

Although the hindered phenol compounds used herein are not particularly limited, the hindered phenol compounds listed below are preferred. 1,3,5-trimethyl-2,4,6-tris(3,5-di-t-butyl-4-hydroxybenzyl)benzene (trade name: IRGANOX 1330), 2,6-di-t-butyl-4-methylphenol (trade name: Sumilizer BHT), 2,5-di-t-butylhydroquinone (trade name: Nocrac NS-7), 2,6-di-t-butyl-4-ethylphenol (trade name: Nocrac M-17), 2,5-di-t-pentylhydroquinone (trade name: Nocrac DAH), 2,2'-methylenebis(4-methyl-6-t-butylphenol) (trade name: Nocrac NS-6), 3,5-di-t-butyl-4-hydroxybenzyl phosphonate diethyl ester (trade name: IRGANOX 1222), 4,4'-thiobis(3-methyl-6-t-butylphenol) (trade name: Nocrac 300), 2,2'-methylenebis(4-ethyl-6-t-butylphenol) (trade name: Nocrac NS-5), 4,4'-butylidenebis(3-methyl-6-t-butylphenol) (trade name: Adeka Stab AO-40), 2-t-butyl-6-(3-t-butyl-2-hydroxy-5-methylbenzyl)-4-methylphenyl acrylate (trade name: Sumilizer GM), 2-[1-(2-hydroxy-3,5-di-t-pentylphenyl)ethyl]-4,6-di-t-pentylphenyl acrylate (trade name: Sumilizer GS), 2,2'-methylenebis[4-methyl-6-(α-methylcyclohexyl)phenol], 4,4'-methylenebis(2,6-di-t-butylphenol) (trade name: Seenox 226M), 4,6-bis(octylthiomethyl)-o-cresol (trade name: IRGANOX 1520L), 2,2'-ethylenebis(4,6-di-t-butylphenol), octadecyl 3-(3,5-di-t-butyl-4-hydroxyphenyl)propionate (trade name: IRGANOX 1076), 1,1,3-tris(2-methyl-4-hydroxy-5-t-butylphenyl)butane (trade name: Adeka Stab AO-30), tetrakis[methylene-(3,5-di-t-butyl-4-hydroxyhydrocinnamate)]methane (trade name: Adeka Stab AO-60), triethylene glycol bis[3-(3-t-butyl-5-methyl-4-hydroxyphenyl)propionate] (trade name: IRGANOX 245), 2,4-bis(n-octylthio)-6-(4-hydroxy-3,5-di-t-butylanilino)-1,3,5-triazine (trade name: IRGANOX 565), N,N'-hexamethylenebis(3,5-di-t-butyl-4-hydroxyhydrocinnamide) (trade name: IRGANOX 1098), 1,6-hexanediol-bis[3-(3,5-di-t-butyl-4-hydroxyphenyl)propionate] (trade name: IRGANOX 259), 2,2-thio-diethylenebis[3-(3,5-di-t-butyl-4-hydroxyphenyl)-propionate] (trade name: IRGANOX 1035), 3,9-bis[2-[3-(3-t-butyl-4-hydroxy-5-methylphenyl)propionyloxy]-1,1-dimethylethyl] 2,4,8,10-tetraoxaspiro[5.5]undecane (trade name: Sumilizer GA-80), tris(3,5-di-t-butyl-4-hydroxybenzyl) isocyanurate (trade name: IRGANOX 3114), bis(ethyl 3,5-di-t-butyl-4-hydroxybenzylphosphonate) calcium/polyethylene wax 50/50 mixture (trade name: IRGANOX 1425WL), isooctyl 3-(3,5-di-t-butyl-4-hydroxyphenyl)propionate (trade name: IRGANOX 1135), 4,4'-thiobis(6-t-butyl-3-methylphenol) (trade name: Sumilizer WX-R), 6-[3-(3-t-butyl-4-hydroxy-5-methylphenyl)propoxy]-2,4,8,10-tetra-t-butyldibenzo[d,f][l,3,2]dioxaphosphepin (trade name: Sumilizer GP), etc.

Although the hindered amine compounds used herein are not particularly limited, the hindered amine compounds listed below are preferred. p,p'-dioctyldiphenylamine (trade name: IRGANOX 5057), phenyl-α-naphthylamine (trade name: Nocrac PA), poly(2,2,4-trimethyl-1,2-dihydroquinoline) (trade name: Nocrac 224, 224-S), 6-ethoxy-2,2,4-trimethyl-1,2-dihydroquinoline (trade name: Nocrac AW), N,N'-diphenyl-p-phenylenediamine (trade name: Nocrac DP), N,N'-di-β-naphthyl-p-phenylenediamine (trade name: Nocrac White), N-phenyl-N'-isopropyl-p-phenylenediamine (trade name: Nocrac 810NA), N,N'-diallyl-p-phenylenediamine (trade name: Nonflex TP), 4,4'-(α,α-dimethylbenzyl)diphenylamine (trade name: Nocrac CD), p,p-toluenesulfonylaminodiphenylamine (trade name: Nocrac TD), N-phenyl-N'-(3-methacryloxy-2-hydroxypropyl)-p-phenylenediamine (trade name: Nocrac G1), N-(1-methylheptyl)-N'-phenyl-p-phenylenediamine (trade name: Ozonon 35), N,N'-di-sec-butyl-p-phenylenediamine (trade name: Sumilizer BPA), N-phenyl-N'-1,3-dimethylbutyl-p-phenylenediamine (trade name: Antigene 6C), alkylated diphenylamine (trade name: Sumilizer 9A), dimethyl-1-(2-hydroxyethyl)-4-hydroxy-2,2,6,6-tetramethylpiperidine succinate polycondensate (trade name: Tinuvin 622LD), poly[[6-(1,1,3,3-tetramethylbutyl)amino]-1,3,5-triazine-2,4-diyl][(2,2,6,6-tetramethyl-4-piperidyl)imino]hexamethylene[(2,2,6,6-tetramethyl-4-piperidyl)imino]] (trade name: CHIMASSORB 944), N,N'-bis(3-aminopropyl)ethylenediamine-2,4-bis[N-butyl-N-(1,2,2,6,6-pentamethyl-4-piperidyl)amino]-6-chloro-1,3,5-triazine condensate (trade name: CHIMASSORB 119FL), bis(1-octyloxy-2,2,6,6-tetramethyl-4-piperidyl)sebacate (trade name: Tinuvin 123), bis(2,2,6,6-tetramethyl-4-piperidyl)sebacate (trade name: Tinuvin 770), bis(1,2,2,6,6-pentamethyl-4-piperidyl) 2-(3,5-di-t-butyl-4-hydroxybenzyl)-2-n-butylmalonate (trade name: Tinuvin 144), bis(1,2,2,6,6-pentamethyl-4-piperidyl)sebacate (trade name: Tinuvin 765), tetrakis(1,2,2,6,6-pentamethyl-4-piperidyl) 1,2,3,4-butanetetracarboxylate (trade name: LA-57), tetrakis(2,2,6,6-tetramethyl-4-piperidyl) 1,2,3,4-butanetetracarboxylate (trade name: LA-52), an esterified mixture of 1,2,3,4-butanetetracarboxylic acid with 1,2,2,6,6-pentamethyl-4-piperidinol and 1-tridecanol (trade name: LA-62), an esterified mixture of 1,2,3,4-butanetetracarboxylic acid with 2,2,6,6-tetramethyl-4-piperidinol and 1-tridecanol (trade name: LA-67), an esterified mixture of 1,2,3,4-butanetetracarboxylic acid with 1,2,2,6,6-pentamethyl-4-piperidinol and 3,9-bis(2-hydroxy-1,1-dimethylethyl)-2,4,8,10-tetraoxaspiro[5.5]undecane (trade name: LA-63P), an esterified mixture of 1,2,3,4-butanetetracarboxylic acid with 2,2,6,6-tetramethyl-4-piperidinol and 3,9-bis(2-hydroxy-1,1-dimethylethyl)-2,4,8,10-tetraoxaspiro[5.5]undecane (trade name: LA-68LD), (2,2,6,6-tetramethylene-4-piperidyl)-2-propylene carboxylate (trade name: Adeka Stab LA-82), (1,2,2,6,6-pentamethyl-4-piperidyl)-2-propylene carboxylate (trade name: Adeka Stab LA-87), etc.

The amount of component (E) used is not particularly limited as long as the benefits of the invention are not impaired. When used, the amount of component (E) is preferably 0.01 to 1% by weight of the resin composition. The antioxidants may be used alone or in admixture.

### (F) Solvent

To the photosensitive resin composition, (F) a solvent may be added in order to facilitate the coating operation. The solvent (F) used herein is not particularly limited as long as components (A) to (E) and other additives (to be described later) are soluble or dispersible therein.

Preferred solvents are organic solvents. Illustrative, non-limiting, examples of the organic solvent include ketones such as cyclohexanone, cyclopentanone and methyl-2-n-pentylketone; alcohols such as 3-methoxybutanol, 3-methyl-3-methoxybutanol, 1-methoxy-2-propanol, and 1-ethoxy-2-propanol; ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; and esters such as propylene glycol monomethyl ether acetate (PGMEA), propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate, and γ-butyrolactone. These solvents may be used alone or in combinations of two or more.

Of these solvents, preferred are ethyl lactate, cyclohexanone, cyclopentanone, PGMEA, γ-butyrolactone, and mixtures thereof, in which the PAG is most soluble.

It is preferred from the standpoints of compatibility and viscosity of the resin composition that the solvent (F) be used in an amount of 200 to 20,000 parts, more preferably 250 to 10,000 parts, and especially 350 to 3,500 parts by weight per 100 parts by weight of components (A) and (C) combined.

### Other additives

Besides the aforementioned components, the photosensitive resin composition may contain optional additives, for example, surfactants which are commonly used for improving coating properties and silane coupling agents.

Preferred surfactants are nonionic surfactants, for example, fluorochemical surfactants such as perfluoroalkyl polyoxyethylene ethanols, fluorinated alkyl esters, perfluoroalkylamine oxides, and fluorinated organosiloxane compounds. These surfactants are commercially available. Illustrative examples include Fluorad® FC-430 from 3M, Surflon® S-141 and S-145 from AGC Seimi Chemical Co., Ltd., Unidyne® DS-401, DS-4031, and DS-451 from Daikin Industries Ltd., Megaface® F-8151 from DIC Corp., and X-70-093 from Shin-Etsu Chemical Co., Ltd. Preferred surfactants are Fluorad FC-430 and X-70-093. The amount of surfactant is not particularly limited as long as the benefits of the invention are not impaired. When used, the amount of the surfactant is preferably 0.01 to 1% by weight of the resin composition.

Inclusion of a silane coupling agent is effective for enhancing the adhesion of the resin composition to adherends. Suitable silane coupling agents include epoxy silane coupling agents and aromatic amino silane coupling agents. The silane coupling agent may be used alone or in admixture. The amount of the silane coupling agent used is not particularly limited as long as the benefits of the invention are not impaired. When used, the amount of the silane coupling agent is preferably 0.01 to 5% by weight of the resin composition.

### Pattern forming process

Another embodiment of the invention is a pattern forming process using the photosensitive resin composition defined above, the process comprising the steps of:
(i) coating the photosensitive resin composition onto a substrate to form a photosensitive resin film thereon,
(ii) exposing the photosensitive resin film to radiation, and
(iii) developing the exposed resin film in a developer.

In step (i), the photosensitive resin composition is coated onto a substrate to form a photosensitive resin film thereon. Examples of the substrate include silicon wafers, glass wafers, quartz wafers, plastic circuit substrates, and ceramic circuit substrates.

The coating technique may be any of well-known techniques such as dipping, spin coating, and roll coating. The coating weight may be selected as appropriate for a particular purpose, preferably so as to form a resin film having a thickness of 1 to 5,000 nm, more preferably 50 to 4,000 nm.

For the purpose of improving the uniformity of film thickness on the substrate surface, pre-wetting may be employed, that is, droplets of a solvent may be applied to the substrate surface before the photosensitive resin composition is coated. Preferred solvents include alcohols such as isopropyl alcohol (IPA), ketones such as cyclohexanone, and glycols such as propylene glycol monomethyl ether (PGME). The solvent used in the photosensitive resin composition may also be used for the pre-wetting.

At this point, the coating may be prebaked to evaporate off the solvent and the like, if necessary, for efficient photo-cure reaction. Prebake may be performed, for example, at 40 to 140°C for 1 minute to about 1 hour.

Next, in step (ii), the photosensitive resin film is exposed to radiation. The exposure radiation is preferably of wavelength 10 to 600 nm, more preferably 190 to 500 nm. Examples of the radiation include radiation of various wavelengths from radiation-emitting units, specifically UV radiation such as g-, h- or i-line and deep UV (248 nm, 193 nm). Radiation of wavelength 248 to 436 nm is especially preferred. An appropriate exposure dose is 10 to 10,000 mJ/cm².

The exposure may be performed through a photomask. The photomask used herein may be, for example, one perforated with a desired pattern. Although the material of the photomask is not particularly limited, a material capable of shielding radiation in the aforementioned wavelength range is preferred. For example, a mask having a light-shielding film of chromium is preferred.

The next step may be post-exposure bake (PEB) which is effective for enhancing development sensitivity. PEB is performed, for example, at 40 to 150°C for 0.5 to 10 minutes. PEB induces crosslinking in the exposed region of resin film, forming an insolubilized pattern which is insoluble in the developer or organic solvent.

Step (iii) following the exposure or PEB is to develop the exposed resin film in a developer to form a pattern. The preferred developers are organic solvents, for example, alcohols such as isopropyl alcohol (IPA), ketones such as cyclohexanone, and glycols such as propylene glycol monomethyl ether (PGME). The solvent used in the photosensitive resin composition may also be used for development. Development is effected in a conventional manner, for example, by dipping the exposed film in the developer. By development in organic solvent-based developers, the unexposed region of the resin film is dissolved away, yielding a pattern. The development is followed by washing, rinsing and drying if necessary. In this way, a resin film having the desired pattern is obtained.

In step (iv), the patterned film may be post-cured in an oven or hot plate at a temperature of preferably 100 to 250°C, more preferably 150 to 220°C. Now that the inventive photosensitive resin composition is used, a resin film having excellent film properties is obtainable even from post-cure at a relatively low temperature around 200°C. A post-cure temperature of 100 to 250°C is preferable as viewed from the standpoints of substrate adhesion, heat resistance, strength, electric properties, and bond strength, because the temperature range is effective for increasing the crosslinking density of the resin film and removing any residual volatile matter. The post-cure time is preferably 10 minutes to 10 hours, more preferably 10 minutes to 3 hours. After the post-cure, the resin film typically has a thickness of 1 to 200 µm, preferably 5 to 50 µm. Through these steps, the desired antireflection film is obtainable.

### EXAMPLES

Examples of the invention are given below by way of illustration and not by way of limitation. Notably, the weight average molecular weight (Mw) is measured versus monodisperse polystyrene standards by GPC under conditions including column TSKgel Super HZM-H (Tosoh Corp.), flow rate 0.6 mL/min, eluent THF, and column temperature 40°C. All parts are by weight (pbw).

Compounds (S-1) to (S-5) used in Examples and Comparative Examples are identified below.

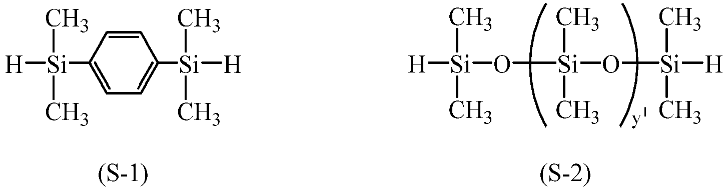

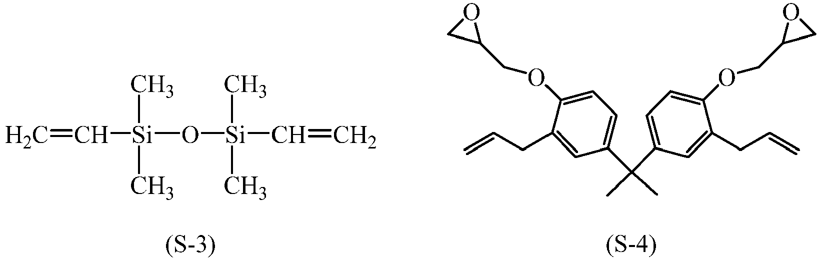

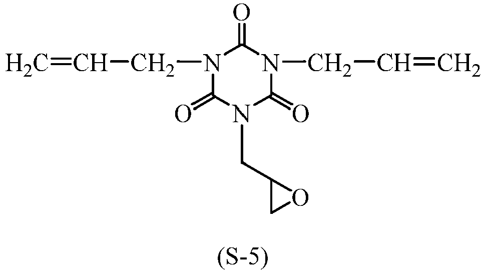

### [1] Synthesis of acid crosslinkable group-containing silicone resin

### Synthesis Example 1

### Synthesis of Resin A-1

A 3-L flask equipped with a stirrer, thermometer, nitrogen purge line, and reflux condenser was charged with 265.0 g (1.00 mol) of Compound (S-5), then with 2,000 g of toluene, and heated at 70°C. Thereafter, 1.0 g of a chloroplatinic acid toluene solution (Pt concentration 0.5 wt%) was added, and 164.9 g (0.85 mol) of Compound (S-1) and 453.0 g (0.15 mol) of Compound (S-2) (y¹=40, by Shin-Etsu Chemical Co., Ltd.) were added dropwise over 1 hour (total hydrosilyl groups/total alkenyl groups = 1/1 in molar ratio). After the completion of dropwise addition, the solution was heated at 100°C and aged for 6 hours. From the reaction solution, the toluene was distilled off in vacuum, yielding Resin A-1. Resin A-1 was analyzed for structure by ¹H-NMR and ²⁹Si-NMR spectroscopy (Bruker Corp.) and GPC. Resin A-1 had a Mw of 65,000 and a silicone content of 51.3 wt%.

### Synthesis Example 2

### Synthesis of Resin A-2

A 3-L flask equipped with a stirrer, thermometer, nitrogen purge line, and reflux condenser was charged with 111.6 g (0.60 mol) of Compound (S-3) and 156.8 g (0.40 mol) of Compound (S-4), then with 2,000 g of toluene, and heated at 70°C. Thereafter, 1.0 g of a chloroplatinic acid toluene solution (Pt concentration 0.5 wt%) was added, and 135.8 g (0.70 mol) of Compound (S-1) and 906.0 g (0.30 mol) of Compound (S-2) (y¹=40, by Shin-Etsu Chemical Co., Ltd.) were added dropwise over 1 hour (total hydrosilyl groups/total alkenyl groups = 1/1 in molar ratio). After the completion of dropwise addition, the solution was heated at 100°C and aged for 6 hours. From the reaction solution, the toluene was distilled off in vacuum, yielding Resin A-2. Resin A-2 was analyzed for structure by ¹H-NMR and ²⁹Si-NMR spectroscopy (Bruker Corp.) and GPC. Resin A-2 had a Mw of 55,000 and a silicone content of 77.7 wt%.

### Synthesis Example 3

### Synthesis of Resin A-3

A 3-L flask equipped with a stirrer, thermometer, nitrogen purge line, and reflux condenser was charged with 111.6 g (0.60 mol) of Compound (S-3) and 106.0 g (0.40 mol) of Compound (S-5), then with 2,000 g of toluene, and heated at 70°C. Thereafter, 1.0 g of a chloroplatinic acid toluene solution (Pt concentration 0.5 wt%) was added, and 174.6 g (0.90 mol) of Compound (S-1) and 302.0 g (0.10 mol) of Compound (S-2) (y¹=40, by Shin-Etsu Chemical Co., Ltd.) were added dropwise over 1 hour (total hydrosilyl groups/total alkenyl groups = 1/1 in molar ratio). After the completion of dropwise addition, the solution was heated at 100°C and aged for 6 hours. From the reaction solution, the toluene was distilled off in vacuum, yielding Resin A-3. Resin A-3 was analyzed for structure by ¹H-NMR and ²⁹Si-NMR spectroscopy (Bruker Corp.) and GPC. Resin A-3 had a Mw of 50,000 and a silicone content of 59.6 wt%.

### Synthesis Example 4

### Synthesis of Resin A-4

A 3-L flask equipped with a stirrer, thermometer, nitrogen purge line, and reflux condenser was charged with 392.0 g (1.00 mol) of Compound (S-4), then with 2,000 g of toluene, and heated at 70°C. Thereafter, 1.0 g of a chloroplatinic acid toluene solution (Pt concentration 0.5 wt%) was added, and 155.2 g (0.80 mol) of Compound (S-1) and 317.0 g (0.20 mol) of Compound (S-2) (y¹=20, by Shin-Etsu Chemical Co., Ltd.) were added dropwise over 1 hour (total hydrosilyl groups/total alkenyl groups = 1/1 in molar ratio). After the completion of dropwise addition, the solution was heated at 100°C and aged for 6 hours. From the reaction solution, the toluene was distilled off in vacuum, yielding Resin A-4. Resin A-4 was analyzed for structure by ¹H-NMR and ²⁹Si-NMR spectroscopy (Bruker Corp.) and GPC. Resin A-4 had a Mw of 23,000 and a silicone content of 36.7 wt%.

### Synthesis Example 5

### Synthesis of Resin A-5

A 3-L flask equipped with a stirrer, thermometer, nitrogen purge line, and reflux condenser was charged with 274.4 g (0.70 mol) of Compound (S-4) and 79.5 g (0.30 mol) of Compound (S-5), then with 2,000 g of toluene, and heated at 70°C. Thereafter, 1.0 g of a chloroplatinic acid toluene solution (Pt concentration 0.5 wt%) was added, and 58.2 g (0.30 mol) of Compound (S-1) and 1109.5 g (0.70 mol) of Compound (S-2) (y¹=20, by Shin-Etsu Chemical Co., Ltd.) were added dropwise over 1 hour (total hydrosilyl groups/total alkenyl groups = 1/1 in molar ratio). After the completion of dropwise addition, the solution was heated at 100°C and aged for 6 hours. From the reaction solution, the toluene was distilled off in vacuum, yielding Resin A-5. Resin A-5 was analyzed for structure by ¹H-NMR and ²⁹Si-NMR spectroscopy (Bruker Corp.) and GPC. Resin A-5 had a Mw of 42,000 and a silicone content of 72.9 wt%.

### Synthesis Example 6

### Synthesis of Resin A-6

A 3-L flask equipped with a stirrer, thermometer, nitrogen purge line, and reflux condenser was charged with 55.8 g (0.30 mol) of Compound (S-3), 117.6 g (0.30 mol) of Compound (S-4), and 106.0 g (0.40 mol) of Compound (S-5), then with 2,000 g of toluene, and heated at 70°C. Thereafter, 1.0 g of a chloroplatinic acid toluene solution (Pt concentration 0.5 wt%) was added, and 135.8 g (0.70 mol) of Compound (S-1) and 475.5 g (0.30 mol) of Compound (S-2) (y¹=20, by Shin-Etsu Chemical Co., Ltd.) were added dropwise over 1 hour (total hydrosilyl groups/total alkenyl groups = 1/1 in molar ratio). After the completion of dropwise addition, the solution was heated at 100°C and aged for 6 hours. From the reaction solution, the toluene was distilled off in vacuum, yielding Resin A-6. Resin A-6 was analyzed for structure by ¹H-NMR and ²⁹Si-NMR spectroscopy (Bruker Corp.) and GPC. Resin A-6 had a Mw of 31,000 and a silicone content of 59.6 wt%.

### Comparative Synthesis Example 1

### Synthesis of Acrylic Resin 1

A flask equipped with a stirrer, thermometer, nitrogen purge line, and reflux condenser was charged with 70 g of PGME and 70 g of toluene. In nitrogen gas atmosphere, the flask was heated at 80°C. While the reaction temperature was maintained at 80°C±2°C, 90 g of methyl methacrylate, 10 g of methacrylic acid, and 2,2'-azobis(isobutyronitrile) were constantly added dropwise over 4 hours. After the dropwise addition, stirring was continued at 80°C±2°C for 6 hours, yielding a solution of Acrylic Resin 1. Acrylic Resin 1 had a Mw of 50,000.

### [2] Preparation and evaluation of photosensitive resin compositions

### Examples 1 to 14 and Comparative Examples 1 to 18

Photosensitive resin compositions of Examples 1 to 14 and Comparative Examples 1 to 18 were prepared by combining various components in accordance with the formulation shown in Tables 1 to 4, agitating, mixing and dissolving at room temperature.

**Table 1**

| Components (pbw) | | Example | | | | | | | | | |
|---|---|---|---|---|---|---|---|---|---|---|---|
| | | 1 | 2 | 3 | 4 | 5 | 6 | 7 | 8 | 9 | 10 |
| (A) Silicone resin | A-1 | 100 | - | - | - | - | - | - | - | - | - |
| | A-2 | - | 100 | - | - | - | - | - | - | - | - |
| | A-3 | - | - | 100 | - | - | - | - | - | - | 100 |
| | A-4 | - | - | - | 100 | - | - | - | - | 100 | - |
| | A-5 | - | - | - | - | 100 | - | - | 100 | - | - |
| | A-6 | - | - | - | - | - | 100 | 100 | - | - | - |
| (B) Photoacid generator | B-1 | 1 | 1 | 1 | 1 | 1 | 1 | 1 | 1 | 1 | 1 |
| (C) Hollow silica | C-1 | 140 | 140 | 140 | - | - | - | 300 | - | 60 | - |
| | C-2 | - | - | - | 140 | 140 | 140 | - | 300 | - | 60 |
| (D) Crosslinker | D-1 | 30 | - | - | 30 | - | - | 30 | - | - | 30 |
| | D-2 | - | 30 | - | - | 30 | - | - | 30 | - | - |
| | D-3 | - | - | 30 | - | - | 30 | - | - | 30 | - |
| (E) Antioxidant | E-1 | 0.1 | 0.1 | 0.1 | 0.1 | 0.1 | 0.1 | 0.1 | 0.1 | 0.1 | 0.1 |
| | E-2 | 0.1 | 0.1 | 0.1 | 0.1 | 0.1 | 0.1 | 0.1 | 0.1 | 0.1 | 0.1 |
| (F) Solvent | cyclopentanone | 5,153 | 5,153 | 5,153 | 5,153 | 5,153 | 5,153 | 8,193 | 8,193 | 3,633 | 3,633 |

**Table 2**

| Components (pbw) | | Example | | | | Comparative Example | |
|---|---|---|---|---|---|---|---|
| | | 11 | 12 | 13 | 14 | 1 | 2 |
| (A) Silicone resin | A-1 | - | 100 | - | - | 100 | - |
| | A-2 | 100 | - | - | - | - | - |
| | A-3 | - | - | - | - | - | - |
| | A-4 | - | - | - | - | - | - |
| | A-5 | - | - | - | - | - | - |
| | A-6 | - | - | 100 | 100 | - | 100 |
| (B) Photoacid generator | B-1 | 5 | 1 | 1 | 1 | 1 | - |
| (C) Hollow silica | C-1 | 140 | - | 140 | - | - | - |
| | C-2 | - | 140 | - | 140 | - | 140 |
| (D) Crosslinker | D-1 | - | - | 90 | - | 30 | - |
| | D-2 | 30 | - | - | - | - | 30 |
| | D-3 | - | 30 | - | - | - | - |
| (E) Antioxidant | E-1 | 0.1 | - | 0.1 | 0.1 | 0.1 | 0.1 |
| | E-2 | 0.1 | - | 0.1 | 0.1 | 0.1 | 0.1 |
| (F) Solvent | cyclopentanone | 5,229 | 5,149 | 6,293 | 4,583 | 2,493 | 5,134 |

**Table 3**

| Components (pbw) | | Comparative Example | | | | | | | |
|---|---|---|---|---|---|---|---|---|---|
| | | 3 | 4 | 5 | 6 | 7 | 8 | 9 | 10 |
| Acrylic resin | Acrylic resin 1 | 50 | 50 | 100 | - | 50 | 50 | 50 | 50 |
| | Acrylic resin 2 | 50 | 50 | - | 100 | 50 | 50 | 50 | 50 |
| Photopolymerization initiator | Irgacure OXE02 | 1 | 1 | 1 | 1 | 2 | 2 | 1 | 1 |
| Hollow silica | C-1 | 100 | - | 100 | - | 45 | 240 | - | - |
| | C-2 | - | 100 | - | 100 | - | - | 45 | 240 |
| Antioxidant | E-1 | 0.1 | 0.1 | 0.1 | 0.1 | 0.1 | 0.1 | - | - |
| | E-2 | 0.1 | 0.1 | 0.1 | 0.1 | 0.1 | 0.1 | - | - |
| Solvent | methyl ethyl ketone | 3,823 | 3,823 | 3,823 | 3,823 | 2,797 | 6,502 | 2,774 | 6,479 |

**Table 4**

| Components (pbw) | | Comparative Example | | | | | | | |
|---|---|---|---|---|---|---|---|---|---|
| | | 11 | 12 | 13 | 14 | 15 | 16 | 17 | 18 |
| Silane compound | tetraethoxysilane | 90 | 90 | 90 | 90 | 90 | 90 | 90 | 50 |
| | (3,3,3-trifluoropropyl) triethoxysilane | 10 | 10 | 10 | 10 | 10 | 10 | 10 | 50 |
| Polymerization catalyst | 0.02 mol/L HCl | 1 | 1 | 1 | 1 | 1 | 1 | 1 | 1 |
| Hollow silica | C-1 | 100 | - | 100 | 240 | 45 | - | - | 100 |
| | C-2 | - | 100 | - | - | - | 240 | 45 | - |
| Antioxidant | E-1 | 0.1 | 0.1 | - | 0.1 | 0.1 | 0.1 | 0.1 | 0.1 |
| | E-2 | 0.1 | 0.1 | - | 0.1 | 0.1 | 0.1 | 0.1 | 0.1 |
| Solvent | isopropanol | 3,823 | 3,823 | 3,819 | 6,483 | 2,778 | 6,483 | 2,778 | 3,823 |

In Tables 1 to 4, hollow silica C-1 is TMPS-1.5 (average particle size 8.8 µm) by Taiyo Kagaku Co., Ltd., and hollow silica C-2 is Thrulya 4320 (average particle size 60 µm) by JGC C&C. Tetraethoxysilane and (3,3,3-trifluoropropyl)triethoxysilane are available from Shin-Etsu Chemical Co., Ltd. Photoacid generator B-1, crosslinkers D-1 to D-3, antioxidants E-1 and E-2, Acrylic Resin 2, and Irgacure OXE02 are identified below.

### Photoacid generator B-1

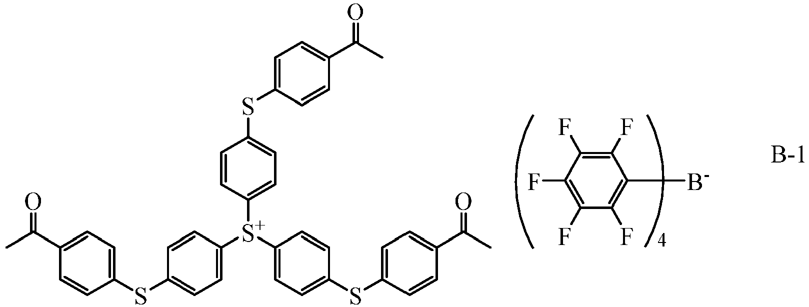

### Crosslinker D-1 (Shin-Etsu Chemical Co., Ltd.)

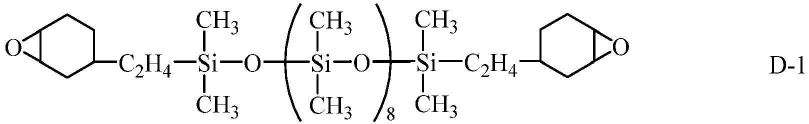

### Crosslinker D-2 (Shikoku Chemicals Corp.)

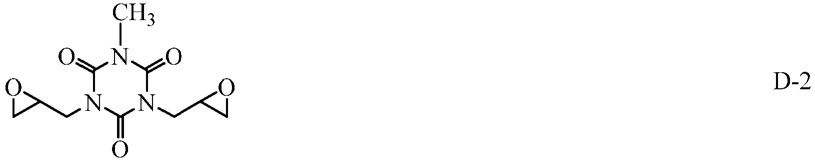

### Crosslinker D-3 (Shikoku Chemicals Corp.)

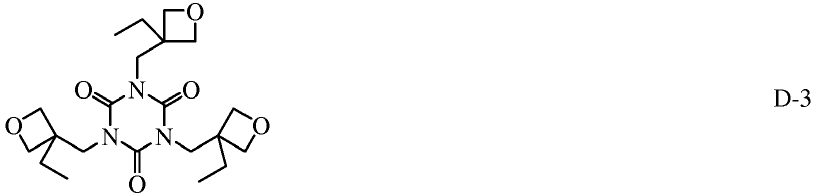

### Antioxidant E-1: Chimassorb 119FL (BASF)

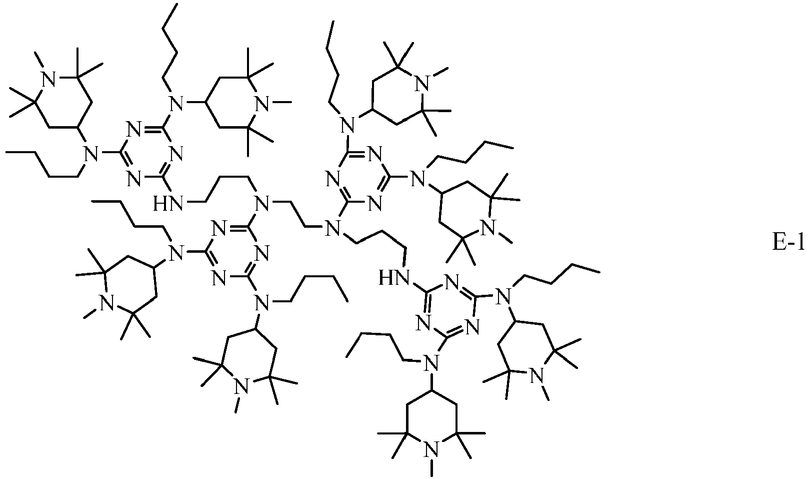

### Antioxidant E-2: Irganox 3114 (BASF)

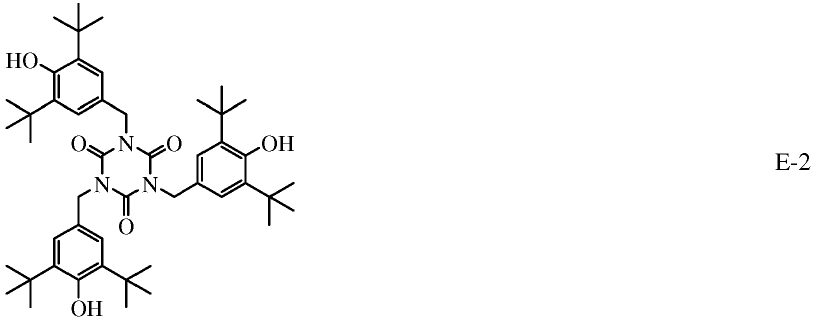

### Acrylic Resin 2: DPCA-20 by Nippon Kayaku Co., Ltd. (ε-caprolactone-modified dipentaerythritol acrylate of the following formula)

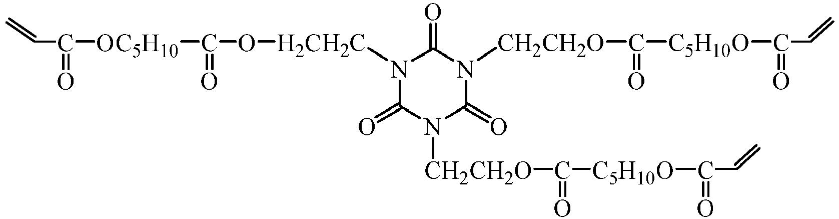

### Irgacure OXE02: ethanone, 1-[9-ethyl-6-(2-methylbenzoyl)-9H-carbazol-3-yl]-,1-(O-acetyloxime) by BASF

### [3] Evaluation of resin film

### (1) Pattern formation and evaluation

Using a spin coater, each photosensitive resin composition was coated onto a glass substrate so as to form a film of 3 µm thick. The coated substrate was rested on a hotplate and heat dried at 110°C for 3 minutes in order to evaporate off the solvent from the composition. Using a contact aligner type exposure system, the photosensitive resin film was exposed to radiation of 365 nm through a mask adapted to form a line-and-space pattern and contact hole pattern. The resin film was post-exposure baked (PEB) on a hotplate at 120°C for 3 minutes and then cooled. The resin film was developed by spraying PGMEA for 60 seconds, forming patterns.

The photosensitive resin film on the substrate which had been patterned as above was post-cured in an oven where the film was heated at 190°C for 2 hours while purging the oven with nitrogen. Under a scanning electron microscope (SEM), the resulting contact hole patterns of 50 µm, 30 µm, 20 µm and 10 µm were observed in cross section. The minimum hole pattern in which holes penetrated through the film to the bottom was reported as maximum resolution. The resin film was rated "NG" in resolution when no patterns could be formed.

### (2) Evaluation of reliability (adhesion and crack resistance)

By operating a dicing saw with a dicing blade (DAD685 by DISCO Corp.) at a spindle revolution of 40,000 rpm and a cutting speed of 20 mm/sec, the substrate bearing the photosensitive resin film (of Examples 1 to 14 and Comparative Examples 1 to 18) which had been patterned and post-cured in (1) was diced into square pieces (test samples) of 10 mm × 10 mm. Ten test samples (for each Example) were subjected to a thermal cycling test of repeating 1,000 cycles of holding at -25°C for 10 minutes and holding at 125°C for 10 minutes. After the thermal cycling test, it was inspected whether or not the resin film peeled from the substrate and whether or not the resin film cracked. The set of samples is rated "OK" when no samples peeled or cracked, "peeled" when one or more samples peeled, and "cracked" when one or more samples cracked.

### (3) Flexibility test

The resin film prepared as above was wound on a spindle of diameter 5 mm, held static for 10 seconds, and unwound. After the winding/unwinding operation was repeated 10 times, the film was inspected for any anomaly. The film is rated "OK" when unchanged and "NG" when fissures or cracks were found.

### (4) Light reflectance measuring test

A film sample on its back surface was rubbed several strokes with sand paper and coated with matte black paint. By using a spectrophotometer U-3310 (Hitachi High-Tech Science Corp.) and directing light of wavelength 400-700 nm at an incident angle of 5°, a reflectance on the front surface was measured. The minimum reflectance (%) in the measurement range is reported as light reflectance.

### (5) Light transmission test 1

Using a spin coater, each photosensitive resin composition was coated onto a 8-inch glass wafer so as to form a resin film of 3 µm thick. The coated wafer was placed on a hotplate and heat dried at 100°C for 5 minutes in order to remove the solvent from the composition.

Using a Mask Aligner MA8 (SUSS MicroTec AG), the film on the glass wafer was exposed over its entire surface to light of wavelength 360 nm from a high-pressure mercury lamp directly, i.e., not through a mask (flood exposure). The film was PEB and dipped in PGMEA. The film which remained after these operations was then heated in an oven at 190°C for 2 hours, yielding a cured film. Using a spectrophotometer U-3900H (Hitachi High-Tech Science Corp.), the cured film was measured for transmittance of light of wavelength 450 nm.

### (6) Light transmission test 2

In an oven at 140°C, the sample in the form of the resin film on glass wafer, prepared as above, was continuously exposed to laser radiation of wavelength 450 nm and power 1 W. After the lapse of 1,000 hours, a transmittance of light of wavelength 450 nm was measured.

The results are shown in Tables 5 to 7.

**Table 5**

| | | Example | | | | | | | | | | | | | |
|---|---|---|---|---|---|---|---|---|---|---|---|---|---|---|---|
| | | 1 | 2 | 3 | 4 | 5 | 6 | 7 | 8 | 9 | 10 | 11 | 12 | 13 | 14 |
| Resin layer thickness (µm) | | 3 | 3 | 3 | 3 | 3 | 3 | 3 | 3 | 3 | 3 | 3 | 3 | 3 | 3 |
| Maximum resolution (µm) | | 10 | 10 | 10 | 10 | 10 | 10 | 20 | 20 | 10 | 10 | 10 | 10 | 10 | 10 |
| Light reflectance (%) | | 0.5 | 0.5 | 0.5 | 0.5 | 0.5 | 0.5 | 0.2 | 0.2 | 0.8 | 0.8 | 0.5 | 0.5 | 0.6 | 0.5 |
| Light transmittance @ 450 nm (%) | Initial | 97 | 97 | 97 | 97 | 97 | 97 | 95 | 95 | 99 | 99 | 97 | 97 | 98 | 97 |
| | after 1,000 hr laser irradiation | 95 | 95 | 95 | 95 | 95 | 95 | 94 | 94 | 94 | 94 | 95 | 93 | 96 | 95 |
| Reliability | Peel | OK | OK | OK | OK | OK | OK | OK | OK | OK | OK | OK | OK | OK | OK |
| | Crack | OK | OK | OK | OK | OK | OK | OK | OK | OK | OK | OK | OK | OK | OK |
| Flexibility | | OK | OK | OK | OK | OK | OK | OK | OK | OK | OK | OK | OK | OK | OK |

**Table 6**

| | | Comparative Example | | | | | | | | | |
|---|---|---|---|---|---|---|---|---|---|---|---|
| | | 1 | 2 | 3 | 4 | 5 | 6 | 7 | 8 | 9 | 10 |
| Resin layer thickness (µm) | | 3 | 3 | 3 | 3 | 3 | 3 | 3 | 3 | 3 | 3 |
| Maximum resolution (µm) | | 10 | NG | 50 | 50 | 50 | 50 | 50 | 50 | 50 | 50 |
| Light reflectance (%) | | 4.3 | 0.6 | 0.6 | 0.6 | 0.6 | 0.6 | 0.9 | 0.3 | 0.9 | 0.3 |
| Light transmittance @ 450 nm (%) | Initial | 100 | 97 | 95 | 95 | 95 | 95 | 97 | 93 | 97 | 93 |
| | after 1,000 hr laser irradiation | 98 | 85 | 88 | 87 | 86 | 87 | 85 | 88 | 83 | 83 |
| Reliabili ty | Peel | peeled | peeled | peeled | peeled | peeled | peeled | peeled | peeled | peeled | peeled |
| | Crack | cracked | cracked | cracked | cracked | cracked | cracked | cracked | cracked | cracked | cracked |
| Flexibility | | OK | NG | NG | NG | NG | NG | NG | NG | NG | NG |

**Table 7**

| | | Comparative Example | | | | | | | |
|---|---|---|---|---|---|---|---|---|---|
| | | 11 | 12 | 13 | 14 | 15 | 16 | 17 | 18 |
| Resin layer thickness (µm) | | 3 | 3 | 3 | 3 | 3 | 3 | 3 | 3 |
| Maximum resolution (µm) | | NG | NG | NG | NG | NG | NG | NG | NG |
| Light reflectance (%) | | 0.6 | 0.6 | 0.6 | 0.3 | 0.9 | 0.3 | 0.9 | 0.6 |
| Light transmittance @ 450 nm (%) | Initial | 96 | 96 | 96 | 94 | 98 | 94 | 98 | 96 |
| | after 1,000 hr laser irradiation | 89 | 89 | 84 | 89 | 87 | 89 | 86 | 89 |
| Reliability | Peel | peeled | peeled | peeled | peeled | peeled | peeled | peeled | peeled |
| | Crack | cracked | cracked | cracked | cracked | cracked | cracked | cracked | cracked |
| Flexibility | | NG | NG | NG | NG | NG | NG | NG | NG |

As is evident from the test results, photosensitive resin compositions within the scope of the invention are easy to form an antireflection film. The cured films of the inventive photosensitive resin compositions function as an antireflection film, and possess light resistance, excellent microprocessing performance factors such as resolution, satisfactory reliability (adhesion, crack resistance), and flexibility.

Although some preferred embodiments have been described, many modifications and variations may be made thereto in light of the above teachings. It is therefore to be understood that the invention may be practiced otherwise than as specifically described without departing from the scope of the appended claims.

## Claims

1. A photosensitive resin composition comprising
(A) an acid crosslinkable group-containing silicone resin having a weight average molecular weight of 3,000 to 500,000,
(B) a photoacid generator, and
(C) hollow silica.

2. The photosensitive resin composition of claim 1 wherein the acid crosslinkable group is an epoxy, oxetane or vinyl ether group.

3. The photosensitive resin composition of claim 2 wherein component (A) is a silicone resin comprising repeating units having the following formulae (A1) to (A6): 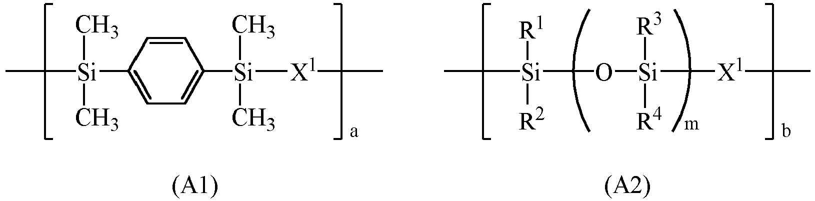 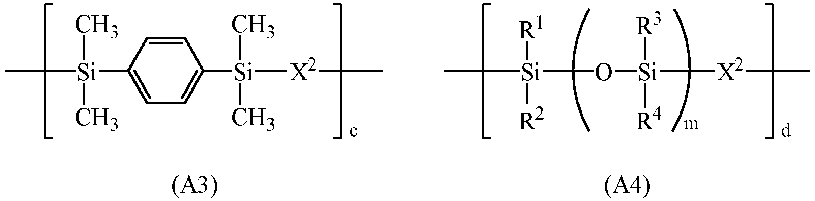 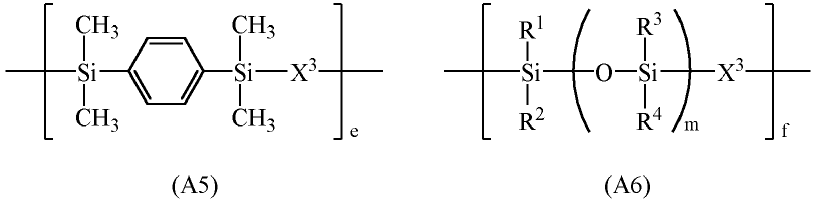
wherein R¹ to R⁴ are each independently a C₁-C₂₀ monovalent hydrocarbon group which may contain a heteroatom, m is each independently an integer of 1 to 600, with the proviso that when m is an integer of at least 2, groups R³ may be identical or different and groups R⁴ may be identical or different, a, b, c, d, e, and f are numbers in the range: 0 ≤ a ≤ 1, 0 ≤ b ≤ 1, 0 ≤ c ≤ 1, 0 ≤ d ≤ 1, 0 ≤ e ≤ 1, 0 ≤ f ≤ 1, 0 < c+d+e+f ≤ 1, and a+b+c+d+e+f=1,
X¹ is a divalent group having the formula (X1): 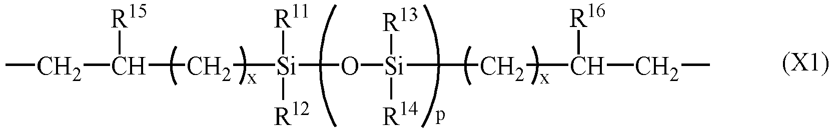 wherein R¹¹ to R¹⁴ are each independently a C₁-C₂₀ monovalent hydrocarbon group which may contain a heteroatom, p is an integer of 1 to 600, with the proviso that when p is an integer of at least 2, groups R¹³ may be identical or different and groups R¹⁴ may be the same or different, R¹⁵ and R¹⁶ are each independently hydrogen or methyl, x is each independently an integer of 0 to 7,
X² is a divalent group having the formula (X2): 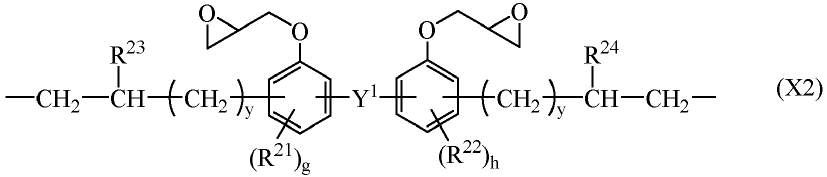 wherein Y¹ is a single bond, methylene, propane-2,2-diyl, 1,1,1,3,3,3-hexafluoropropane-2,2-diyl, or fluorene-9,9-diyl, R²¹ and R²² are each independently a C₁-C₄ alkyl or alkoxy group, with the proviso that when g is 2, groups R²¹ may be identical or different, when h is 2, groups R²² may be identical or different, R²³ and R²⁴ are each independently hydrogen or methyl, y is each independently an integer of 0 to 7, g and h are each independently 0, 1 or 2,
X³ is a divalent group having the formula (X3): 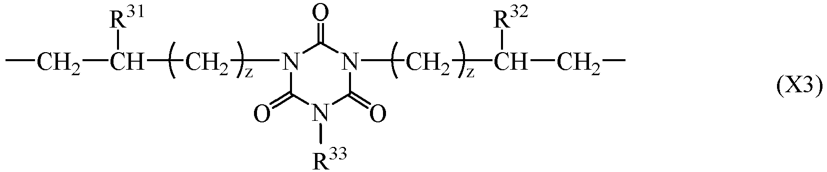 wherein R³¹ and R³² are each independently hydrogen or methyl, z is each independently an integer of 0 to 7, R³³ is a C₁-C₈ monovalent hydrocarbon group which may contain an ester bond or ether bond, or a monovalent group having the formula (X3-1): 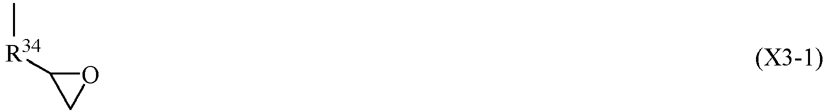 wherein R³⁴ is a C₁-C₈ divalent hydrocarbon group which may contain an ester bond or ether bond.

4. The photosensitive resin composition of any one of claims 1 to 3 wherein the hollow silica (C) has an average particle size of up to 1 µm.

5. The photosensitive resin composition of any one of claims 1 to 4 wherein the hollow silica (C) is present in an amount of 20 to 90% by weight of the composition.

6. The photosensitive resin composition of any one of claims 1 to 5, further comprising (D) a crosslinker.

7. The photosensitive resin composition of any one of claims 1 to 6, further comprising (E) an antioxidant.

8. The photosensitive resin composition of any one of claims 1 to 7, further comprising (F) a solvent.

9. A pattern forming process comprising the steps of:
(i) coating the photosensitive resin composition of any one of claims 1 to 8 onto a substrate to form a photosensitive resin film thereon,
(ii) exposing the photosensitive resin film to radiation, and
(iii) developing the exposed resin film in a developer.

10. A method for preparing an antireflection film, involving the pattern forming process of claim 9, the antireflection film comprising the patterned photosensitive resin film.

11. An antireflection film comprising the photosensitive resin composition of any one of claims 1 to 8.

12. An article comprising the antireflection film of claim 11.

## Patentansprüche

1. Photosensitive Harzzusammensetzung, umfassend:
(A) ein Silikonharz, welches eine säurevernetzende Gruppe enthält und ein mittleres Molekulargewicht von 3.000 bis 500.000 aufweist,
(B) einen Photosäuregenerator und
(C) hohles Siliziumdioxid.

2. Photosensitive Harzzusammensetzung nach Anspruch 1, wobei die säurevernetzende Gruppe eine Epoxid-, Oxetan- oder Vinylethergruppe ist.

3. Photosensitive Harzzusammensetzung nach Anspruch 2, wobei Komponente (A) ein Silikonharz ist, welches sich wiederholende Einheiten umfasst, welche die folgenden Formeln (A1) bis (A6) aufweisen: 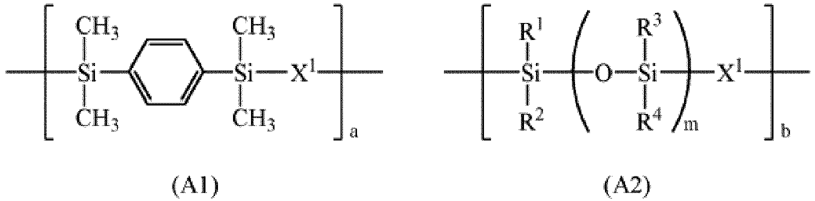 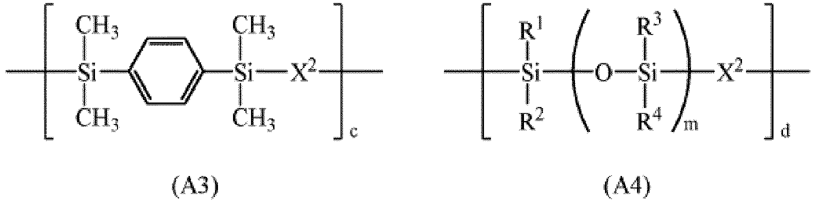 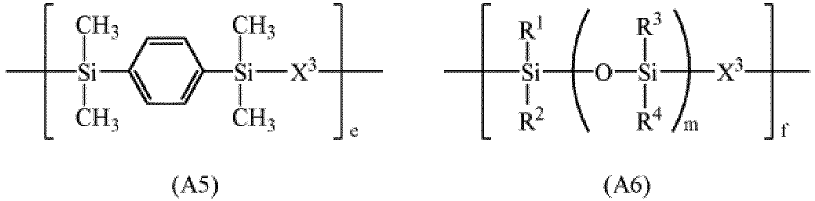
wobei R¹ bis R⁴ jeweils unabhängig eine monovalente C₁-C₂₀-Kohlenwasserstoffgruppe sind, welche ein Heteroatom enthalten kann, wobei m jeweils unabhängig eine ganze Zahl von 1 bis 600 ist, mit der Maßgabe, dass, wenn m eine ganze Zahl von mindestens 2 ist, die Gruppen R³ identisch oder unterschiedlich sein können und die Gruppen R⁴ identisch oder unterschiedlich sein können, wobei a, b, c, d, e und f Zahlen in dem Bereich 0 ≤ a ≤ 1, 0 ≤ b ≤ 1, 0 ≤ c ≤ 1, 0 ≤ d ≤ 1, 0 ≤ e ≤ 1, 0 ≤ f ≤ 1, 0 < c+d+e+f ≤ 1, und a+b+c+d+e+f=1 sind,
wobei X¹ eine divalente Gruppe ist, welche die Formel (X1) aufweist: 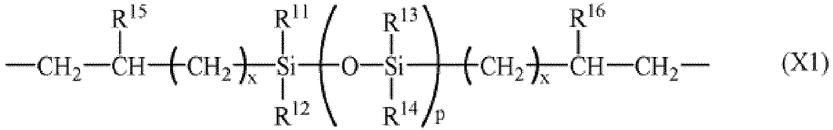 wobei R¹¹ bis R¹⁴ jeweils unabhängig eine monovalente C₁-C₂₀-Kohlenwasserstoffgruppe sind, welche ein Heteroatom enthalten kann, wobei p eine ganze Zahl von 1 bis 600 ist, mit der Maßgabe, dass, wenn p eine ganze Zahl von mindestens 2 ist, die Gruppen R¹³ identisch oder unterschiedlich sein können und die Gruppen R¹⁴ gleich oder unterschiedlich sein können, R¹⁵ und R¹⁶ jeweils unabhängig Wasserstoff oder Methyl sind, x jeweils unabhängig eine ganze Zahl von 0 bis 7 ist,
wobei X² eine divalente Gruppe ist, welche die Formel (X2) aufweist: 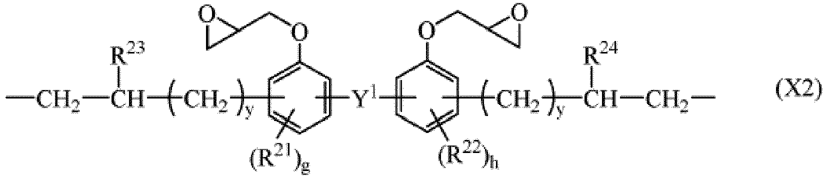 wobei Y¹ eine Einfachbindung, Methylen, Propan-2,2-diyl, 1,1,1,3,3,3-Hexafluorpropan-2,2-diyl oder Fluoren-9,9-diyl ist, R²¹ und R²² jeweils unabhängig eine C₁-C₄-Alkyl oder Alkoxygruppe sind, mit der Maßgabe, dass, wenn g 2 ist, die Gruppen R²¹ identisch oder unterschiedlich sein können, dass, wenn h 2 ist, die Gruppen R²² identisch oder unterschiedlich sein können, R²³ und R²⁴ jeweils unabhängig Wasserstoff oder Methyl sind, y jeweils unabhängig eine ganze Zahl von 0 bis 7 ist, g und h jeweils unabhängig 0, 1 oder 2 sind,
wobei X³ eine divalente Gruppe ist, welche die Formel (X3) aufweist: 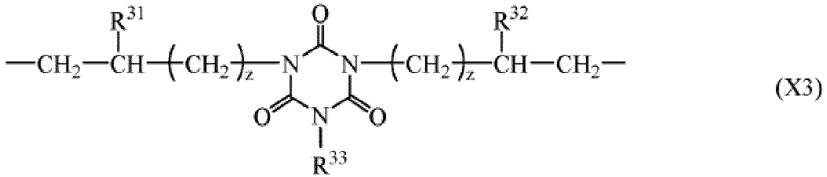 wobei R³¹ und R³² jeweils unabhängig Wasserstoff oder Methyl sind, z jeweils unabhängig eine ganze Zahl von 0 bis 7 ist, R³³ eine monovalente C₁-C₈-Kohlenwasserstoffgruppe, welche eine Esterbindung oder eine Etherbindung enthalten kann, oder eine monovalente Gruppe ist, welche die Formel (X3-1) aufweist: 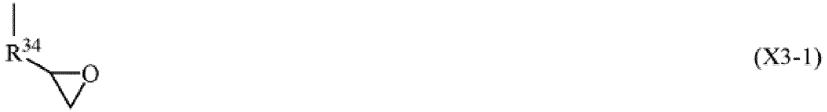 wobei R³⁴ eine divalente C₁-C₈-Kohlenwasserstoffgruppe ist, welche eine Esterbindung oder eine Etherbindung enthalten kann.

4. Photosensitive Harzzusammensetzung nach einem der Ansprüche 1 bis 3, wobei das hohle Siliziumdioxid (C) eine durchschnittliche Partikelgröße von bis zu 1 µm aufweist.

5. Photosensitive Harzzusammensetzung nach einem der Ansprüche 1 bis 4, wobei das hohle Siliziumdioxid (C) in einer Menge von 20 bis 90 Gew.-% der Zusammensetzung vorhanden ist.

6. Photosensitive Harzzusammensetzung nach einem der Ansprüche 1 bis 5, ferner umfassend (D) einen Vernetzer.

7. Photosensitive Harzzusammensetzung nach einem der Ansprüche 1 bis 6, ferner umfassend (E) ein Antioxidationsmittel.

8. Photosensitive Harzzusammensetzung nach einem der Ansprüche 1 bis 7, ferner umfassend (F) ein Lösungsmittel.

9. Musterbildungsprozess, umfassend die folgenden Schritte:
(i) Beschichten eines Substrats mit der photosensitiven Harzzusammensetzung nach einem der Ansprüche 1 bis 8, um eine photosensitive Harzschicht darauf zu bilden,
(ii) Aussetzen der photosensitiven Harzschicht gegenüber einer Bestrahlung und
(iii) Entwickeln der ausgesetzten Harzschicht in einem Entwickler.

10. Verfahren zum Herstellen einer Antireflexionsschicht, wobei das Verfahren den Musterbildungsprozess nach Anspruch 9 involviert, wobei die Antireflexionsschicht die gemusterte photosensitive Harzschicht umfasst.

11. Antireflexionsschicht, umfassend die photosensitive Harzzusammensetzung nach einem der Ansprüche 1 bis 8.

12. Artikel, umfassend die Antireflexionsschicht nach Anspruch 11.

## Revendications

1. Composition de résine photosensible comprenant
(A) une résine de silicone contenant un groupe réticulable acide ayant une masse moléculaire moyenne en poids de 3 000 à 500 000,
(B) un photogénérateur d'acide, et
(C) de la silice creuse.

2. Composition de résine photosensible selon la revendication 1 dans laquelle le groupe réticulable acide est un groupe époxy, oxétane ou éther vinylique.

3. Composition de résine photosensible selon la revendication 2 dans laquelle un constituant (A) est une résine de silicone comprenant des unités récurrentes ayant les formules (A1) à (A6) suivantes : 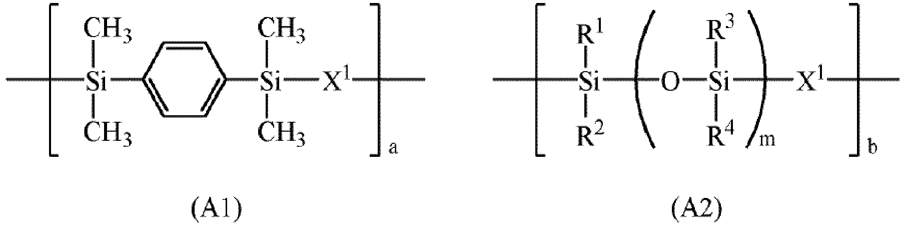 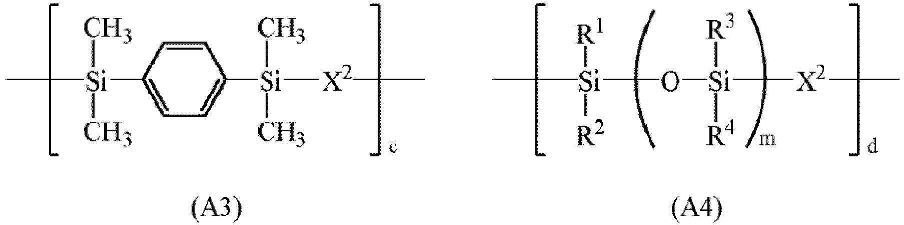 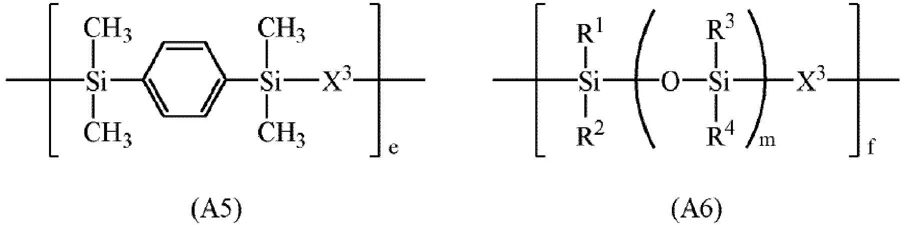
dans lesquelles R¹ à R⁴ sont chacun indépendamment un groupe hydrocarboné monovalent C₁-C₂₀ qui peut contenir un hétéroatome, m est chacun indépendamment un nombre entier de 1 à 600, à condition que lorsque m est un nombre entier d'au moins 2, les groupes R³ puissent être identiques ou différents et les groupes R⁴ puissent être identiques ou différents, a, b, c, d, e et f sont des nombres dans la plage : 0 ≤ a ≤ 1, 0 ≤ b ≤ 1, 0 ≤ c ≤ 1, 0 ≤ d ≤ 1, 0 ≤ e ≤ 1, 0 ≤ f ≤ 1, 0<c + d + e + f ≤ 1, et a + b + c + d + e + f = 1,
X¹ est un groupe divalent ayant la formule (X1) : 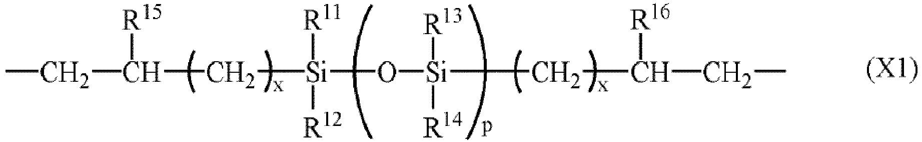 dans laquelle R¹¹ à R¹⁴ sont chacun indépendamment un groupe hydrocarboné monovalent C₁-C₂₀ qui peut contenir un hétéroatome, p est un nombre entier de 1 à 600, à condition que lorsque p est un nombre entier d'au moins 2, les groupes R¹³ puissent être identiques ou différents et les groupes R¹⁴ puissent être les mêmes ou différents, R¹⁵ et R¹⁶ sont chacun indépendamment de l'hydrogène ou du méthyle, x est chacun indépendamment un nombre entier de 0 à 7,
X² est un groupe divalent ayant la formule (X2) : 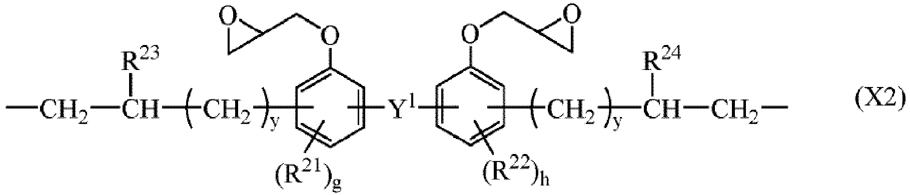 dans laquelle Y¹ est une liaison simple, du méthylène, du propane-2,2-diyle, du 1,1,1,3,3,3-hexafluoropropane-2,2-diyle, ou du fluorène-9,9-diyle, R²¹ et R²² sont chacun indépendamment un groupe alkyle ou alkoxy C₁-C₄, à condition que lorsque g est 2, les groupes R²¹ puissent être identiques ou différents, lorsque h est 2, les groupes R²² puissent être identiques ou différents, R²³ et R²⁴ sont chacun indépendamment de l'hydrogène ou du méthyle, y est chacun indépendamment un nombre entier de 0 à 7, g et h sont chacun indépendamment 0, 1 ou 2,
X³ est un groupe divalent ayant la formule (X3) : 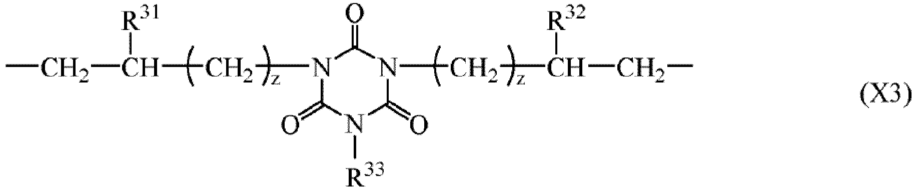 dans laquelle R³¹ et R³² sont chacun indépendamment de l'hydrogène ou du méthyle, z est chacun indépendamment un nombre entier de 0 à 7, R³³ est un groupe hydrocarboné monovalent C₁-C₈ qui peut contenir une liaison ester ou une liaison éther, ou un groupe monovalent ayant la formule (X3-1) : 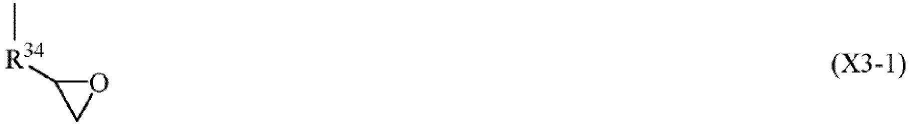 dans laquelle R³⁴ est un groupe hydrocarboné divalent C₁-C₈ qui peut contenir une liaison ester ou une liaison éther.

4. Composition de résine photosensible selon l'une quelconque des revendications 1 à 3 dans laquelle la silice creuse (C) a une dimension moyenne des particules jusqu'à 1 µm.

5. Composition de résine photosensible selon l'une quelconque des revendications 1 à 4 dans laquelle la silice creuse (C) est présente dans une quantité de 20 à 90 % en poids de la composition.

6. Composition de résine photosensible selon l'une quelconque des revendications 1 à 5, comprenant en outre (D) un agent de réticulation.

7. Composition de résine photosensible selon l'une quelconque des revendications 1 à 6, comprenant en outre (E) un antioxydant.

8. Composition de résine photosensible selon l'une quelconque des revendications 1 à 7, comprenant en outre (F) un solvant.

9. Procédé de formation de motifs comprenant les étapes consistant à :
(i) revêtir un substrat de la composition de résine photosensible selon l'une quelconque des revendications 1 à 8 pour former un film de résine photosensible sur celui-ci,
(ii) exposer le film de résine photosensible à un rayonnement, et
(iii) développer le film de résine exposé dans un développateur.

10. Procédé permettant de préparer un film antireflet, impliquant le procédé de formation de motifs selon la revendication 9, le film antireflet comprenant le film de résine photosensible à motifs.

11. Film antireflet comprenant la composition de résine photosensible selon l'une quelconque des revendications 1 à 8.

12. Article comprenant le film antireflet selon la revendication 11.
